# EUROPEAN PATENT SPECIFICATION

(11) **EP 4 514 084 B1**
(45) Date of publication and mention of the grant of the patent: **01.07.2026**
(21) Application number: 23849404.1
(22) Date of filing: 01.08.2023
(51) Int. Cl.: H05K 7/20, G06F 1/16, H04M 1/02

(54) **FOLDABLE DEVICE**
ZUSAMMENKLAPPBARE VORRICHTUNG
DISPOSITIF PLIABLE

(30) Priority: 02.08.2022 CN 202210922397
(43) Date of publication of application: 26.02.2025
(60) Divisional application: 26172445.4
(73) Proprietor: Huawei Technologies Co., Ltd., Shenzhen, Guangdong 518129 (CN)
(72) Inventor: LIU, Yu, Shenzhen, Guangdong 518129 (CN); LIN, Xiangchen, Shenzhen, Guangdong 518129 (CN); SUN, Yong, Shenzhen, Guangdong 518129 (CN); ZHU, Xu, Shenzhen, Guangdong 518129 (CN); ZHOU, Xiao, Shenzhen, Guangdong 518129 (CN)
(74) Representative: Grünecker Patent- und Rechtsanwälte PartG mbB
(86) International application number: PCT/CN2023/110524
(87) International publication number: WO 2024/027698

(56) References cited:
- WO-A1-2021/196832
- WO-A1-2022/158881
- CN-A- 111 913 546
- CN-A- 113 810 529
- CN-U- 209 593 495
- CN-U- 219 019 328
- US-A1- 2020 204 666

## Description

### TECHNICAL FIELD

Embodiments of the present disclosure relate to the field of electronic device technologies, and in particular, to a foldable device.

### BACKGROUND

As electronic device technologies such as smart phones or tablet computers develop, electronic devices have increasingly more functions. A larger area of a display of an electronic device may make use experience of some functions of the electronic device better. However, a larger area of the display of the electronic device causes a larger overall size of the electronic device, and consequently it is inconvenient to carry the electronic device. To make it more convenient to carry electronic devices with large display areas, flexible displays may be used as displays in some electronic devices, and the electronic devices can be made into foldable devices.

In some related technologies, a foldable device includes a flexible display, a rotating shaft mechanism, and two housings respectively mounted on two sides of the rotating shaft mechanism. The two housings are rotatably connected through the rotating shaft mechanism, so that the foldable device can switch between a folded state and an unfolded state. The flexible display is mounted on the two housings. The flexible display may be folded and unfolded under driving of the two housings. Heating units such as a camera and a mainboard module may be disposed in at least one housing. Heat generated by the heating units may be conducted to the housing in which the heating units are located, and the heat is dissipated to an external environment through the housing in which the heating units are located. US2020204666A1 relates to a foldable electronic device including a heat dissipation structure utilizing an inner space of a hinge housing, and it relates to a foldable electronic device that controls a sudden temperature change of a flexible display via a heat dissipation structure.

However, in foldable devices in the related technologies, some housings are prone to overheating.

### SUMMARY

Embodiments of the present disclosure provide a foldable device. A flexible thermal sheet that crosses a rotating shaft mechanism and is thermally connected to different housings is disposed between the different housings, so that heat on the different housings is mutually conducted, heat generated by a heating unit in any housing may be dissipated through a plurality of housings. A temperature difference between different housings is small, and each housing is not prone to overheating. The present invention is defined according to the independent claims. The dependent claims recite advantageous embodiments of the invention.

The present disclosure provides a foldable device, including a first housing, a second housing, a heating unit, a rotating shaft mechanism, a flexible display, and a flexible thermal sheet. The first housing and the second housing are rotatably connected through the rotating shaft mechanism, and a heating unit is disposed in at least one of the first housing and the second housing. The flexible display includes a first part, a second part, and a third part. The first part is mounted on the first housing, and a first chamber is provided between the first part and the first housing. The second part is mounted on the second housing, and a second chamber is provided between the second part and the second housing. The third part is opposite to the rotating shaft mechanism, a third chamber is provided between the third part and the rotating shaft mechanism, and two ends of the third chamber respectively communicate with the first chamber and the second chamber. The flexible thermal sheet is disposed in space formed by the first chamber, the second chamber, and the third chamber, at least a part that is of the flexible thermal sheet and that is located in the first chamber is fastened to the first housing, the flexible thermal sheet passes through the third chamber along the third part and extends to the second chamber, and the flexible thermal sheet slidably cooperates with the third part and the rotating shaft mechanism and with the second part and the second housing. The flexible thermal sheet is thermally connected to the heating unit, the first housing, and the second housing.

According to the foldable device in this embodiment of the present disclosure, the flexible thermal sheet that is thermally connected to the first housing and the second housing is disposed, so that heat on the first housing and the second housing can be mutually conducted, heat generated by heating units in the first housing and the second housing may be dissipated to an external environment through the first housing and the second housing together. In the first housing and the second housing, heat on one housing in which a heating unit generating a larger amount of heat is disposed may be transferred to the other housing with a smaller amount of heat and a lower temperature, a temperature difference between the first housing and the second housing is small, the housing in which a heating unit generating a larger amount of heat is disposed is not prone to overheating, and heat dissipation performance of the heating unit generating a larger amount of heat does not need to be improved by thickening a thermal pad, so that the flexible thermal sheet may be light and thin. In addition, the flexible thermal sheet slidably cooperates with the third part and the rotating shaft mechanism and with the second part and the second housing, parts of the flexible thermal sheet located in the second chamber and the third chamber are not fastened. When the foldable device is in a process of switching between an unfolded state and a folded state, the parts of the flexible thermal sheet in the second chamber and the third chamber may slide along the second part and the third part. This can reduce a risk that the flexible thermal sheet is pulled or compressed and wrinkled when the foldable device switches between the unfolded state and the folded state, and the flexible thermal sheet is not easily clamped into the rotating shaft mechanism and gaps between the rotating shaft mechanism and the first housing and the second housing. This can reduce an impact of the flexible thermal sheet on unfolding and folding of the foldable device. In addition, the flexible thermal sheet is smooth when the foldable device is in each state, and this can reduce an impact on display of the flexible display.

In a possible implementation, the flexible thermal sheet includes a graphite sheet part and a laminated part, the graphite sheet part is located in the first chamber and is fastened to the first housing, the laminated part passes through the third chamber along the third part and extends to the second chamber, and the laminated part slidably cooperates with the third part and the rotating shaft mechanism and with the second part and the second housing. The laminated part includes a graphite sheet layer and an elastic support layer that are stacked, and the elastic support layer is fastened to the graphite sheet layer.

In a possible implementation, one end that is of the laminated part and that is connected to the graphite sheet part is located in the first chamber, and at least a part that is of the laminated part and that is located in the first chamber is fastened to the first housing.

In a possible implementation, the elastic support layer includes metal, and rigidity of the metal is greater than rigidity of the graphite sheet layer.

In a possible implementation, the elastic support layer is fastened to a side surface that is of the graphite sheet layer and that is close to the flexible display.

In a possible implementation, the elastic support layer includes a first end away from the graphite sheet part in a first direction, the graphite sheet layer includes a second end away from the graphite sheet part in the first direction, and the first end protrudes from the second end. The second housing is fastened to Mylar, Mylar is located in the second chamber, Mylar is spaced apart from the second end in the first direction, at least a part of Mylar and a part that is of the elastic support layer and that protrudes from the second end overlap in a thickness direction of the second housing, and the first end slidably cooperates with Mylar. The first direction is a direction in which the first housing faces the second housing when the foldable device is in the unfolded state.

In a possible implementation, Mylar is Teflon Mylar.

In a possible implementation, the elastic support layer includes a first side and a second side opposite to each other in a second direction, the graphite sheet layer includes a third side and a fourth side opposite to each other in the second direction, the first side is adjacent to the third side, the second side is adjacent to the fourth side, the third side protrudes from the first side, and the fourth side protrudes from the second side. A width, in the second direction, of a part that is of the graphite sheet layer and that protrudes from the first side is less than a height of the second chamber in a thickness direction of the foldable device and is less than a height of the third chamber in the thickness direction of the foldable device. A width, in the second direction, of a part that is of the graphite sheet layer and that protrudes from the second side is less than the height of the second chamber in the thickness direction of the foldable device and is less than the height of the third chamber in the thickness direction of the foldable device. The second direction is a length extension direction of the rotating shaft mechanism.

In a possible implementation, the graphite sheet part and the graphite sheet layer are of an integrated structure, and a thickness of the graphite sheet part is greater than a thickness of the graphite sheet layer.

In a possible implementation, a thickness of the elastic support layer is less than the thickness of the graphite sheet layer.

In a possible implementation, a first bonding layer is disposed between the graphite sheet layer and the elastic support layer, and the graphite sheet layer and the elastic support layer are bonded and fastened through the first bonding layer.

In a possible implementation, when the heating unit is disposed in the first housing, a projection of the heating unit in the first housing along a thickness direction of the first housing falls within a range of a projection of the part that is of the flexible thermal sheet and that is located in the first chamber along the thickness direction of the first housing.

In a possible implementation, the heating unit is disposed in the first housing. When the heating unit is also disposed in the second housing, heat generated when the heating unit in the first housing runs is greater than heat generated when the heating unit in the second housing runs.

In a possible implementation, a lubricating medium is disposed between the rotating shaft mechanism and the flexible thermal sheet.

In a possible implementation, a lubricating medium is disposed between the third part and the flexible thermal sheet.

In a possible implementation, a lubricating medium is disposed between the rotating shaft mechanism and the flexible thermal sheet and between the third part and the flexible thermal sheet.

In a possible implementation, at least the part that is of the flexible thermal sheet and that is located in the first chamber is bonded and fastened to the first housing through a second bonding layer.

In a possible implementation, a second bonding layer is disposed between the flexible thermal sheet and the first housing, and the flexible thermal sheet is bonded and fastened to the first housing through the second bonding layer.

In a possible implementation, a second bonding layer is disposed between the flexible thermal sheet and the heating unit in the first housing, and the flexible thermal sheet is bonded and fastened to the heating unit in the first housing through the second bonding layer, so that the flexible thermal sheet is fastened to the first housing through the second bonding layer and the heating unit in the first housing.

In a possible implementation, second bonding layers are disposed between the flexible thermal sheet and the first housing and between the flexible thermal sheet and the heating unit in the first housing, and the flexible thermal sheet is separately bonded and fastened to the first housing and the heating unit in the first housing through the second bonding layers.

In a possible implementation, the part that is of the flexible thermal sheet and that is located in the first chamber is provided with positioning holes, the first housing is provided with positioning protrusions corresponding to the positioning holes, and the positioning protrusions extend into the corresponding positioning holes.

In a possible implementation, the first part is bonded and fastened to the first housing through a first bonding strip, and the second part is bonded and fastened to the second housing through a second bonding strip. The first chamber is provided between the first part, the first bonding strip, and the first housing, and the second chamber is provided between the second part, the second bonding strip, and the second housing.

In a possible implementation, the first bonding strip is disposed at an edge of the first part, and the second bonding strip is disposed at an edge of the second part.

### BRIEF DESCRIPTION OF DRAWINGS

FIG. 1 is a diagram of an angle of view of a foldable device in a folded state according to an embodiment of the present disclosure;
FIG. 2 is a diagram of an angle of view of a foldable device in an unfolded state according to an embodiment of the present disclosure;
FIG. 3 is another diagram of a side that is of a foldable device in an unfolded state and on which a flexible display is disposed according to an embodiment of the present disclosure;
FIG. 4 is another diagram in which a first rear cover is hidden when a foldable device is in an unfolded state according to an embodiment of the present disclosure;
FIG. 5 is another diagram in which a flexible display is hidden when a foldable device is in an unfolded state according to an embodiment of the present disclosure;
FIG. 6 is another diagram of a foldable device in a folded state according to an embodiment of the present disclosure;
FIG. 7 is another diagram of an intermediate state of a foldable device in a process of switching between a folded state and an unfolded state according to an embodiment of the present disclosure;
FIG. 8 is another diagram of a foldable device in an unfolded state according to an embodiment of the present disclosure;
FIG. 9 is another diagram of a side of a flexible thermal sheet of a foldable device in a thickness direction of the flexible thermal sheet according to an embodiment of the present disclosure;
FIG. 10 is another diagram of another side of a flexible thermal sheet of a foldable device in a thickness direction of the flexible thermal sheet according to an embodiment of the present disclosure;
FIG. 11 is another diagram of a side, in a second direction, of a joint between a graphite sheet part and a laminated part of a flexible thermal sheet of a foldable device according to an embodiment of the present disclosure;
FIG. 12 is another diagram of a side, in a second direction, of a joint between a graphite sheet part and a laminated part of a flexible thermal sheet of a foldable device according to an embodiment of the present disclosure;
FIG. 13 is another diagram of a cross section perpendicular to a second direction at a third part and a laminated part of a foldable device according to an embodiment of the present disclosure;
FIG. 14 is an enlarged view of a part A in FIG. 5;
FIG. 15 is another diagram in which a flexible display and a flexible thermal sheet on a side that is of a foldable device in an unfolded state and on which a flexible display is disposed are hidden according to an embodiment of the present disclosure;
FIG. 16 is another diagram of cooperation between a laminated part and Mylar in a process in which a foldable device switches from an unfolded state to a folded state according to an embodiment of the present disclosure;
FIG. 17 is an enlarged view of a part B in FIG. 10;
FIG. 18 is another diagram of a side that is of a foldable device in an unfolded state and on which a flexible display is disposed according to an embodiment of the present disclosure;
FIG. 19 is another diagram of a side that is of a foldable device in an unfolded state and on which a flexible display is disposed according to an embodiment of the present disclosure;
FIG. 20 is another diagram of a side that is of a foldable device in an unfolded state and on which a flexible display is disposed according to an embodiment of the present disclosure; and
FIG. 21 is another diagram of a side that is of a foldable device in an unfolded state and on which a flexible display is disposed according to an embodiment of the present disclosure.

### Reference numerals:

110: first housing; 111: first bonding strip; 112; first middle frame; 113 : first rear cover; 114: first mounting plate;
120: second housing; 121: second bonding strip; 122: second middle frame; 123: second rear cover; 124: second mounting plate;
200: rotating shaft mechanism; 210: primary shaft component; 220: first folding component; 230: second folding component;
300: flexible display; 310: first part; 320: second part; 330: third part;
400: heating unit;
510: first chamber; 511: second bonding layer; 520: second chamber; 530: third chamber;
600: flexible thermal sheet; 610: graphite sheet part; 611: positioning holes; 620: laminated part; 621: graphite sheet layer; 622: elastic support layer; 623: first end; 624: second end; 625: first side; 626: second side; 627: third side; 628: fourth side; 629: first bonding layer;
700: lubricating medium; and
800: Mylar.

### DESCRIPTION OF EMBODIMENTS

Terms used in implementations of the present disclosure are only used to explain specific embodiments of the present disclosure, and are not intended to limit the present disclosure. The following will describe the implementations of embodiments of the present disclosure in detail with reference to the accompanying drawings.

Embodiments of the present disclosure provide a foldable device, and a form of the foldable device may be changed through folding and unfolding, to meet requirements of a user in different scenarios. For example, when being carried, the foldable device may be folded to reduce a size of the foldable device; and when being used, the foldable device may be unfolded to increase a size of a screen used for display or operation. It may be understood that the foldable device may also be referred to as user equipment (user equipment, UE), a terminal (terminal), or the like.

The foldable device provided in embodiments of the present disclosure may include but is not limited to a mobile terminal or a stationary terminal such as a tablet computer (portable Android device, PAD), a personal digital assistant (personal digital assistant, PDA), a handheld device with a wireless communication function, a computing device, a vehicle-mounted device, a wearable device, a virtual reality (virtual reality, VR) terminal device, an augmented reality (augmented reality, AR) terminal device, a wireless terminal in industrial control (industrial control), a wireless terminal in self driving (self driving), a wireless terminal in a telemedicine (remote medical), a wireless terminal in a smart grid (smart grid), a wireless terminal in transportation safety (transportation safety), a wireless terminal in a smart city (smart city), or a wireless terminal in a smart home (smart home). In embodiments of the present disclosure, a handheld device having a wireless communication function is used as an example for description, and the handheld device having the wireless communication function may be a mobile phone.

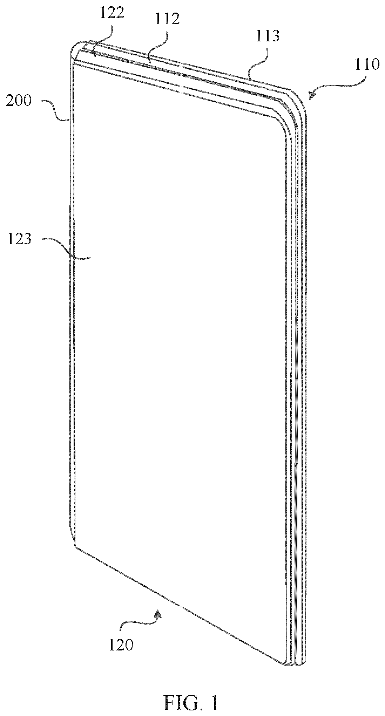

FIG. 1 is a diagram of an angle of view of a foldable device in a folded state according to an embodiment of the present disclosure.

As shown in FIG. 1, the foldable device provided in this embodiment of the present disclosure includes a first housing 110, a second housing 120, and a rotating shaft mechanism 200. The first housing 110 and the second housing 120 are respectively mounted on two sides of the rotating shaft mechanism 200, and the first housing 110 and the second housing 120 are rotatably connected through the rotating shaft mechanism 200, so that the foldable device can switch between an unfolded state and a folded state.

It may be understood that, when the first housing 110 and the second housing 120 rotate relative to each other to be mutually stacked, the foldable device is in the folded state. In this case, the first housing 110 and the second housing 120 may be parallel to each other. A person skilled in the art may understand that, when the foldable device is in the unfolded state, due to reasons such as a design tolerance, the two mechanical parts are parallel to each other, but may not be absolutely parallel, and a slight deviation is allowed. When the first housing 110 and the second housing 120 rotate relative to each other until an included angle between the first housing 110 and the second housing 120 is approximately 180°, the foldable device is in the unfolded state. A person skilled in the art may understand that an included angle between the two mechanical parts in the present disclosure document is approximately 180°, and may not be absolute 180° due to reasons such as a design tolerance, and a slight deviation is allowed. For example, the included angle may be 165°, 177°, or 185°. Certainly, the foldable device further has an intermediate state in a process of switching between the folded state and the unfolded state.

For example, the first housing 110 may include a first middle frame 112 and a first rear cover 113, and the first rear cover 113 is fastened to one side of the first middle frame 112 in a thickness direction of the first middle frame 112; the second housing 120 may include a second middle frame 122 and a second rear cover 123, and the second rear cover 123 is fastened to one side of the second middle frame 122 in a thickness direction of the second middle frame 122; and the first middle frame 112 and the second middle frame 113 are respectively mounted on the two sides of the rotating shaft mechanism 200, and the first middle frame 112 and the second middle frame 113 are rotatably connected through the rotating shaft mechanism 200. When the foldable device is in the unfolded state, an included angle between the first middle frame 112 and the second middle frame 122 is approximately 180°, and an included angle between the first rear cover 113 and the second rear cover 123 is approximately 180°. When the foldable device is in the folded state, the first middle frame 112 and the second middle frame 122 may be parallel to each other, the first rear cover 113 and the second rear cover 123 may be parallel to each other, the first rear cover 113 is located on a side that is of the first middle frame 112 and that is away from the second middle frame 122, and the second rear cover 123 is located on a side that is of the second middle frame 122 and that is away from the first middle frame 112.

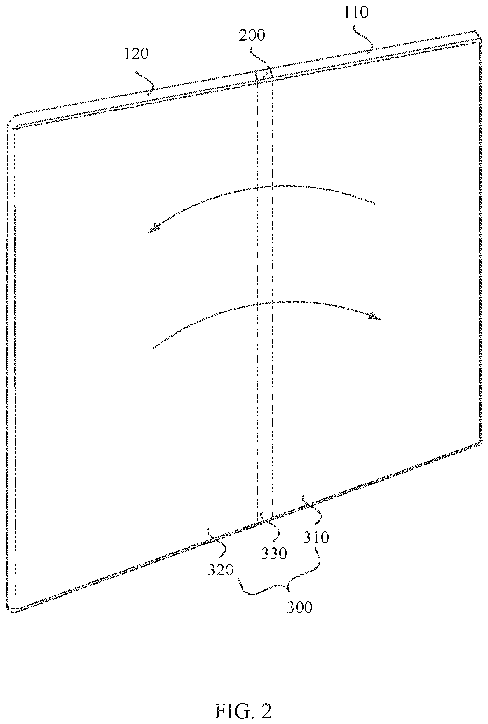

FIG. 2 is a diagram of an angle of view of the foldable device in the unfolded state according to an embodiment of the present disclosure.

The foldable device provided in this embodiment of the present disclosure further includes a flexible display 300, and the flexible display 300 is mounted on the first housing 110 and the second housing 120.

It may be understood that the flexible display 300 is mounted on surfaces of a same side of the first housing 110 and the second housing 120. After the flexible display 300 is mounted on the first housing 110 and the second housing 120, the rotating shaft mechanism 200 may be configured to support the flexible display 300.

In an example in which the first housing 110 includes the first middle frame 112 and the first rear cover 113 and the second housing 120 includes the second middle frame 122 and the second rear cover 123, a side surface that is of the first middle frame 112 and that is away from the first rear cover 113 is used to mount the flexible display 300, and a side surface that is of the second middle frame 122 and that is away from the second rear cover 123 is used to mount the flexible display 300.

The flexible display 300 may be configured to display an image, and may also be used as a virtual keyboard to enter information. A function of the flexible display 300 may be determined based on a specific application scenario.

For example, the flexible display 300 may be an organic light-emitting diode (organic light-emitting diode, OLED) display, an active-matrix organic light-emitting diode (active-matrix organic light-emitting diode, AMOLED) display, a mini light-emitting diode (mini organic light-emitting diode) display, a micro light-emitting diode (micro light-emitting diode) display, a micro organic light-emitting diode (micro organic light-emitting diode) display, or a quantum dot light-emitting diode (quantum dot light-emitting diode) display.

In this embodiment of the present disclosure, the flexible display 300 includes a first part 310, a second part 320, and a third part 330. The first part 310 is mounted on the first housing 110, the second part 320 is mounted on the second housing 120, and the third part 330 is opposite to the rotating shaft mechanism 200. It may be understood that the first part 310 may be mounted on the first housing 110 in a manner of bonding, clamping, or the like, the second part 320 may be mounted on the second housing 120 in a manner of bonding, clamping, or the like, and two sides of the third part 330 are respectively connected to the first part 310 and the second part 320.

Specifically, in an example in which the first housing 110 may include the first middle frame 112 and/or the first rear cover 113 and the second housing 120 may include the second middle frame 122 and/or the second rear cover 123, the first part 310 may be mounted on a side that is of the first middle frame 112 and that is away from the first rear cover 113, and the second part 320 may be mounted on a side that is of the second middle frame 122 and that is away from the second rear cover 123.

It may be understood that, when the foldable device switches from the unfolded state to the folded state, the first part 310 and the second part 320 may rotate with the first housing 110 and the second housing 120, the third part 330 is bent, and the first part 310 and the second part 320 may not be bent, or a bending angle is very small and the first part 310 and the second part 320 are almost flat. When the foldable device switches from the folded state to the unfolded state, the bent third part 330 is unfolded, so that the first part 310, the second part 320, and the third part 330 are in a same plane (a slight deviation is allowed).

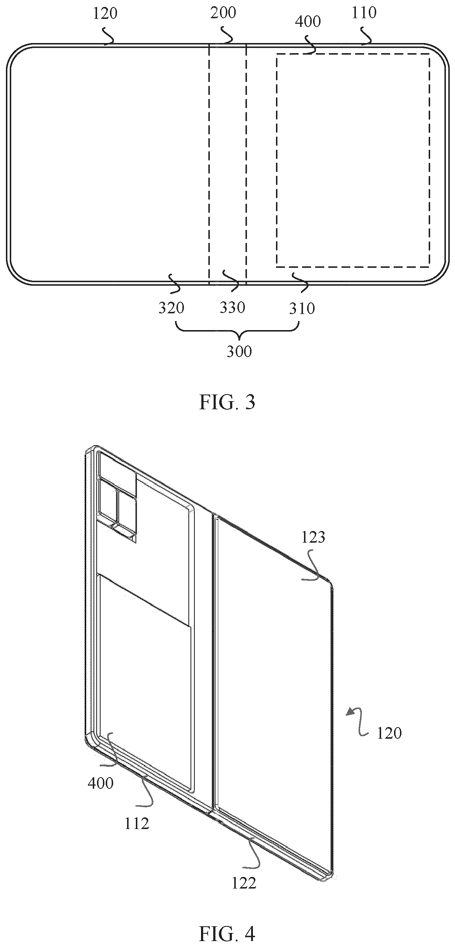

FIG. 3 is another diagram of a side that is of the foldable device in the unfolded state and on which the flexible display is disposed according to an embodiment of the present disclosure.

As shown in FIG. 3, a heating unit 400 is further disposed in at least one of the first housing 110 and the second housing 120 of the foldable device provided in this embodiment of the present disclosure.

It may be understood that the heating unit 400 may be disposed on a circuit board in the first housing 110, and the heating unit 400 may not be disposed in the second housing 120. Alternatively, the heating unit 400 may be disposed on a circuit board in the second housing 120, and the heating unit 400 may not be disposed in the first housing 110. Alternatively, the heating unit 400 may be disposed on both the circuit board in the first housing 110 and the circuit board in the second housing 120.

FIG. 4 is another diagram in which the first rear cover is hidden when the foldable device is in the unfolded state according to an embodiment of the present disclosure.

As shown in FIG. 4, in an example in which the first housing 110 includes the first middle frame 112 and the first rear cover 113, the heating unit 400 in the first housing 110 may be disposed in space formed by the first middle frame 112 and the first rear cover 113, the circuit board on which the heating unit 400 is disposed in the first housing 110 may be mounted in an accommodation cavity of the first middle frame 112, and the heating unit 400 may be thermally connected to the first middle frame 112 and the first rear cover 113. Specifically, the heating unit 400 in the first housing 110 may be thermally connected to the first middle frame 112 and the first rear cover 113 in a manner of being in contact with or close to at least one of the first middle frame 112 and the first rear cover 113.

In an example in which the second housing 120 includes the second middle frame 122 and the second rear cover 123, the heating unit 400 in the second housing 120 may be disposed in space formed by the second middle frame 122 and the second rear cover 123, the circuit board on which the heating unit 400 is disposed in the second housing 120 may be mounted in an accommodation cavity of the second middle frame 122, and the heating unit 400 may be thermally connected to the second middle frame 122 and the second rear cover 123. Specifically, the heating unit 400 in the second housing 120 may be thermally connected to the second middle frame 122 and the second rear cover 123 in a manner of being in contact with or close to at least one of the second middle frame 122 and the second rear cover 123.

It should be noted that the heating unit 400 is a component that generates heat or a module including a plurality of components. For example, the heating unit 400 may be a chip like a central processing unit (central processing unit, CPU) or a graphics processing unit (graphics processing unit, GPU), or may be a component like a power supply, a resistor, or a camera, or may be a mainboard module integrated with a plurality of components. One or more heating units 400 may be disposed in the first housing 110, and one or more heating units 400 may also be disposed in the second housing 120.

When components are disposed in chambers of both the first housing 110 and the second housing 120, the components in the first housing 110 and the second housing 120 may be electrically connected through a flexible circuit board, and the flexible circuit board may extend from the first housing 110 through the rotating shaft mechanism 200 to the second housing 120, so that the components in the chambers of the first housing 110 and the second housing 120 are electrically connected. In an example in which the first housing 110 includes the first middle frame 112 and the first rear cover 113 and the second housing 120 includes the second middle frame 122 and the second rear cover 123, the flexible circuit board may be disposed on sides that are of the first middle frame 112 and the second middle frame 122 and that are away from the flexible display 300. In other words, the first middle frame 112 and the second middle frame 122 may be located between the flexible display 300 and the flexible circuit board.

For a foldable device in some related technologies, heat generated by the heating unit 400 disposed in a chamber of the first housing 110 is conducted to the first housing 110, and then the heat is dissipated to an external environment through the first housing 110; and heat generated by the heating unit 400 disposed in a chamber of the second housing 120 is conducted to the second housing 120, and then the heat is dissipated to the external environment through the second housing 120. For some foldable devices in which thermal pads are separately disposed in the first housing 110 and the second housing 120, the thermal pads are independently disposed in the first housing 110 and the second housing 120 in the foldable device in the related technology. In other words, the thermal pad in the first housing 110 does not pass through or cross the rotating shaft mechanism 200 and extend to the second housing 120, and the thermal pad in the second housing 120 does not pass through or cross the rotating shaft mechanism 200 and extend to the first housing 110. The thermal pad in the first housing 110 may be configured to quickly and evenly conduct the heat generated by the heating unit 400 in the first housing 110 to each position in the first housing 110, the thermal pad in the second housing 120 may be configured to quickly and evenly conduct heat generated by the heating unit 400 in the second housing 120 to each position in the second housing 120. Regardless of whether a thermal pad is disposed in the foldable device, heat on the first housing 110 and the second housing 120 cannot be mutually conducted, the heat generated by the heating unit 400 in the first housing 110 is dissipated through the first housing 110, and the heat generated by the heating unit 400 in the second housing 120 is dissipated through the second housing 120. When heat on the first housing 110 or the second housing 120 is high, a heat dissipation capability may be insufficient. In the foldable device, heat generated by the heating units 400 in the first housing 110 and the second housing 120 is usually uneven. One housing in which a heating unit 400 generating a larger amount of heat is disposed has a larger amount of heat and a higher temperature, and the other housing has a smaller amount of heat and a lower temperature. Alternatively, when no heating unit 400 is disposed in one of the first housing 110 and the second housing 120, one housing in which a heating unit 400 is disposed has a larger amount of heat and a higher temperature, and the other housing has a smaller amount of heat and a lower temperature. In the conventional technology, a heat mutual conduction capability of the first housing 110 and the second housing 120 is limited, and a temperature difference between the first housing 110 and the second housing 120 is large. Therefore, one of the first housing 110 and the second housing 120 that has a larger amount of heat and a higher temperature is prone to overheating.

For example, the mainboard module generates a large amount of heat during working. When the mainboard module is disposed in the first housing 110, heat generated by the mainboard module cannot be effectively dissipated through the first housing 110 and the second housing 120, and the first housing 110 is prone to overheating.

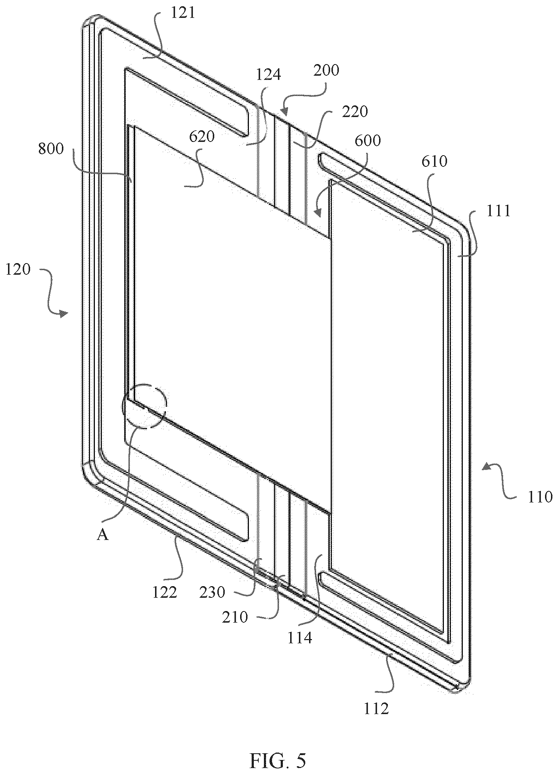

FIG. 5 is another diagram in which the flexible display is hidden when the foldable device is in the unfolded state according to an embodiment of the present disclosure.

Based on this, as shown in FIG. 5, the foldable device provided in this embodiment of the present disclosure further includes a flexible thermal sheet 600. It may be understood that the flexible thermal sheet 600 is a bendable thermal pad. The flexible thermal sheet 600 may be a metal sheet like a thin copper sheet or a thin aluminum sheet, or may be a thermal pad with composite structural layers such as graphite and thermally conductive rubber. For example, the flexible thermal sheet 600 may be a thermal pad including a graphite layer and an elastic metal layer.

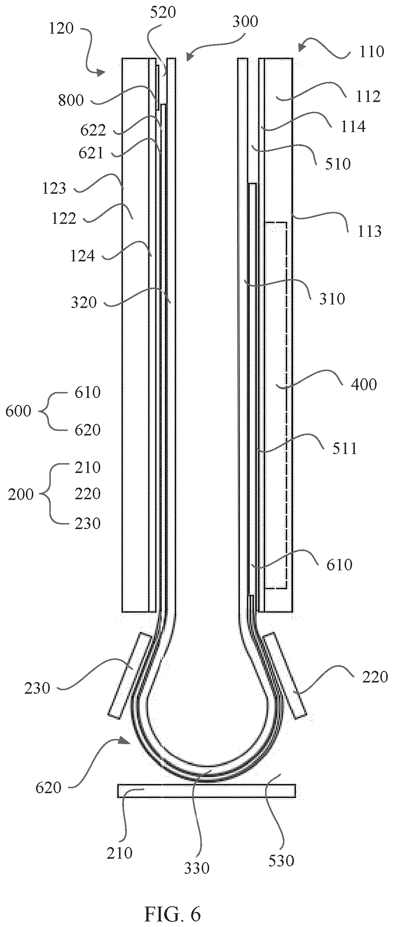

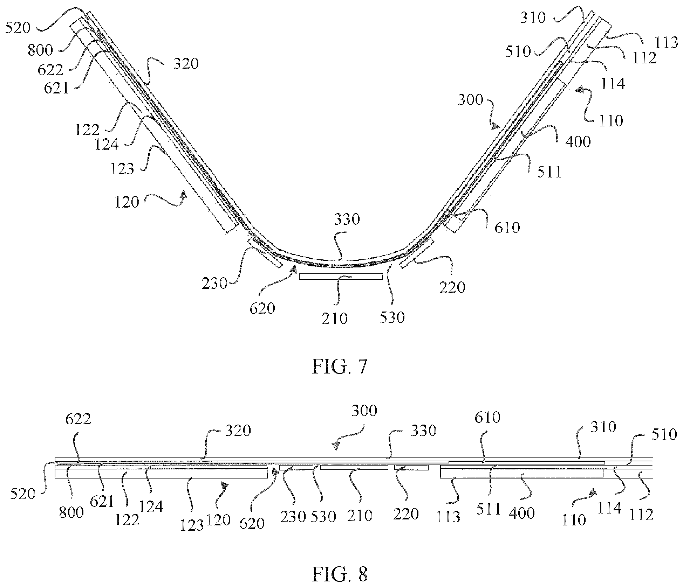

FIG. 6 is another diagram of the foldable device in the folded state according to an embodiment of the present disclosure. FIG. 7 is another diagram of an intermediate state of the foldable device in a process of switching between the folded state and the unfolded state according to an embodiment of the present disclosure. FIG. 8 is another diagram of the foldable device in the unfolded state according to an embodiment of the present disclosure.

As shown in FIG. 6 to FIG. 8, in embodiments of the present disclosure, there is a first chamber 510 between the first part 310 of the flexible display 300 and the first housing 110, and there is a second chamber 520 between the second part 320 of the flexible display 300 and the second housing 120, a third chamber 530 is provided between the third part 330 of the flexible display 300 and the rotating shaft mechanism 200, and two ends of the third chamber 530 respectively communicate with the first chamber 510 and the second chamber 520. The flexible thermal sheet 600 is disposed in space formed by the first chamber 510, the second chamber 520, and the third chamber 530. At least a part that is of the flexible thermal sheet 600 and that is located in the first chamber 510 is fastened to the first housing 110. The flexible thermal sheet 600 passes through the third chamber 530 along the third part 330 and extends to the second chamber 520. The flexible thermal sheet 600 slidably cooperates with the third part 330 and the rotating shaft mechanism 200 and with the second part 320 and the second housing 120. The flexible thermal sheet 600 is thermally connected to the heating unit 400, the first housing 110, and the second housing 120.

It may be understood that the flexible thermal sheet 600 may be disposed in contact with the first housing 110 or close to the first housing 110, so that the flexible thermal sheet 600 is thermally connected to the first housing 110. The flexible thermal sheet 600 may be disposed in contact with the second housing 120 or close to the second housing 120, so that the flexible thermal sheet 600 is thermally connected to the second housing 120. The first housing 110 and the second housing 120 are thermally connected through the flexible thermal sheet 600, and heat on the first housing 110 and the second housing 120 may be mutually transferred through the flexible thermal sheet 600.

When the heating unit 400 is disposed in the first housing 110, the heating unit 400 in the first housing 110 may be disposed in contact with the flexible thermal sheet 600 or close to the flexible thermal sheet 600, so that the heating unit 400 in the first housing 110 is thermally connected to the flexible thermal sheet 600. In this case, the heating unit 400 in the first housing 110 may be thermally connected to the first housing 110 through the flexible thermal sheet 600.

Alternatively, the heating unit 400 in the first housing 110 may be disposed in contact with the first housing 110 or close to the first housing 110, so that the heating unit 400 in the first housing 110 is thermally connected to the first housing 110. The heating unit 400 in the first housing 110 may be thermally connected to the flexible thermal sheet 600 through the first housing 110.

Alternatively, the heating unit 400 in the first housing 110 may be disposed in contact with the flexible thermal sheet 600 or close to the flexible thermal sheet 600, and the heating unit 400 in the first housing 110 may be disposed in contact with the first housing 110 or close to the first housing 110, so that the heating unit 400 in the first housing 110 is thermally connected to both the first housing 110 and the flexible thermal sheet 600.

In other words, the heating unit 400 in the first housing 110 may first transfer heat to the first housing 110, and transfer the heat to the flexible thermal sheet 600 through the first housing 110. Alternatively, the heating unit 400 in the first housing 110 may first transfer heat to the flexible thermal sheet 600, and transfer the heat to the first housing 110 through the flexible thermal sheet 600. The heating unit 400 in the first housing 110 may alternatively transfer heat to both the flexible thermal sheet 600 and the first housing 110.

Similarly, when the heating unit 400 is disposed in the second housing 120, the heating unit 400 in the second housing 120 may be disposed in contact with the flexible thermal sheet 600 or close to the flexible thermal sheet 600, so that the heating unit 400 in the second housing 120 is thermally connected to the flexible thermal sheet 600. In this case, the heating unit 400 in the second housing 120 may be thermally connected to the second housing 120 through the flexible thermal sheet 600.

Alternatively, the heating unit 400 in the second housing 120 may be disposed in contact with the second housing 120 or close to the second housing 120, so that the heating unit 400 in the second housing 120 is thermally connected to the second housing 120. The heating unit 400 in the second housing 120 may be thermally connected to the flexible thermal sheet 600 through the second housing 120.

Alternatively, the heating unit 400 in the second housing 120 may be disposed in contact with the flexible thermal sheet 600 or close to the flexible thermal sheet 600, and the heating unit 400 in the second housing 120 may be disposed in contact with the second housing 120 or close to the second housing 120, so that the heating unit 400 in the second housing 120 is thermally connected to both the second housing 120 and the flexible thermal sheet 600.

In other words, the heating unit 400 in the second housing 120 may first transfer heat to the second housing 120, and transfer the heat to the flexible thermal sheet 600 through the second housing 120. Alternatively, the heating unit 400 in the second housing 120 may first transfer heat to the flexible thermal sheet 600, and transfer the heat to the second housing 120 through the flexible thermal sheet 600. The heating unit 400 in the second housing 120 may alternatively transfer heat to both the flexible thermal sheet 600 and the second housing 120.

It should be noted that a projection of the heating unit 400 in a thickness direction of the foldable device may completely or partially fall within a range of a projection of the flexible thermal sheet 600 in the thickness direction of the foldable device.

When the heating unit 400 in the first housing 110 is thermally connected to the flexible thermal sheet 600 through the first housing 110, a projection of the heating unit 400 in the first housing 110 in the thickness direction of the foldable device may not fall within the range of the projection of the flexible thermal sheet 600 in the thickness direction of the foldable device.

When the heating unit 400 in the second housing 120 is thermally connected to the flexible thermal sheet 600 through the second housing 120, a projection of the heating unit 400 in the second housing 120 in the thickness direction of the foldable device may not fall within the range of the projection of the flexible thermal sheet 600 in the thickness direction of the foldable device.

It may be understood that an end part of the flexible thermal sheet 600 located in the second chamber 520 is a free end, and may slide back and forth between the second part 320 and the second housing 120.

In this way, the flexible thermal sheet 600 thermally connects the first housing 110 and the second housing 120, and heat on the first housing 110 and the second housing 120 may be mutually conducted, heat generated by heating units 400 in the first housing 110 and the second housing 120 may be dissipated to an external environment through the first housing 110 and the second housing 120 together. In the first housing 110 and the second housing 120, heat on one housing in which a heating unit 400 generating a larger amount of heat is disposed may be transferred to the other housing with a smaller amount of heat and a lower temperature, a temperature difference between the first housing 110 and the second housing 120 is small, the housing in which a heating unit 400 generating a larger amount of heat is disposed is not prone to overheating, and heat dissipation performance of the heating unit 400 generating a larger amount of heat does not need to be improved by thickening a thermal pad, so that the flexible thermal sheet 600 may be light and thin. In addition, the flexible thermal sheet 600 slidably cooperates with the third part 330 and the rotating shaft mechanism 200 and with the second part 320 and the second housing 120, parts of the flexible thermal sheet 600 located in the second chamber 520 and the third chamber 530 are not fastened. When the foldable device is in a process of switching between the unfolded state and the folded state, the parts of the flexible thermal sheet 600 in the second chamber 520 and the third chamber 530 may slide along the second part 320 and the third part 330. This can reduce a risk that the flexible thermal sheet 600 is pulled or compressed and wrinkled when the foldable device switches between the unfolded state and the folded state, and the flexible thermal sheet 600 is not easily clamped into the rotating shaft mechanism 200 and gaps between the rotating shaft mechanism 200 and the first housing 110 and the second housing 120. This can reduce an impact of the flexible thermal sheet 600 on unfolding and folding of the foldable device. In addition, the flexible thermal sheet 600 is smooth when the foldable device is in each state, and this can reduce an impact on display of the flexible display 300.

It may be understood that, in an example in which the first housing 110 includes the first middle frame 112 and the first rear cover 113, and the second housing 120 includes the second middle frame 122 and the second rear cover 123, a side that is of the first middle frame 112 and that faces the first part 310 may be spaced apart from the first part 310, a side that is of the second middle frame 122 and that faces the second part 320 is spaced apart from the second part 320, the first chamber 510 is formed between the side that is of the first middle frame 112 and that faces the first part 310 and the first part 310, and the second chamber 520 is formed between the side that is of the second middle frame 122 and that faces the second part 320 and the second part 320. The first part 310 and the second part 320 may be connected to the first middle frame 112 and the second middle frame 122 respectively through structures such as a connection frame and a bonding strip, and are spaced from the first middle frame 112 and the second middle frame 122 to form the first chamber 510 and the second chamber 520 respectively. Alternatively, a step structure configured to form the first chamber 510 with the first part 310 may be disposed on the side that is of the first middle frame 112 and that faces the first part 310, and a step structure configured to form the second chamber 520 with the second part 320 may be disposed on the side that is of the second middle frame 112 and that faces the second part 320.

When a flexible circuit board is disposed on sides that are of the first middle frame 112 and the second middle frame 122 and that are away from the flexible display 300, the first middle frame 112 and the second middle frame 122 may be located between the flexible circuit board and the flexible thermal sheet 600.

It should be noted that the foldable device may include one first housing 110 and one second housing 120 that are disposed on two sides of one rotating shaft mechanism 200. The first housing 110 and the second housing 120 may rotate toward each other to be stacked or rotate backward to a same plane (where a slight deviation is allowed). In this case, the foldable device can be folded into two layers.

The foldable device may alternatively include two second housings 120 disposed in parallel, one first housing 110 is disposed between the two second housings 120, and each second housing 120 is rotatably connected to an adjacent side of the first housing 110 through the rotating shaft mechanism 200. In this case, both the two second housings 120 may rotate relative to the first housing 110 to be stacked, or the two second housings 120 may rotate backward relative to the first housing 110 to be coplanar with the first housing 110 (where a slight deviation is allowed). In this case, the foldable device can be folded into three layers. Correspondingly, the flexible display 300 includes two second parts 320 respectively mounted on the two second housings 120 and two third parts 330 respectively opposite to the two rotating shaft mechanisms 200, and the second chamber 520 is provided between each second housing 120 and the second part 320 mounted on the second housing 120, the third chamber 530 is provided between each rotating shaft mechanism 200 and the third part 330 opposite to the rotating shaft mechanism 200. Two ends of the flexible thermal sheet 600 may respectively extend along the two third parts 330 to the two second chambers 520 on the two sides of the first chamber 510. The flexible thermal sheet 600 slidably cooperates with the two third parts 330, the two rotating shaft mechanisms 200, the two second parts 320, and the two second housings 120. The flexible thermal sheet 600 is thermally connected to both the two second housings 120.

As shown in FIG. 5 to FIG. 8, in some examples, the first housing 110 may alternatively include a first mounting plate 114 disposed on the side that is of the first middle frame 112 and that faces the first part 310. The first mounting plate 114 is fastened to the first middle frame 112. The first part 310 is mounted on the first mounting plate 114. The first mounting plate 114 is spaced apart from the first part 310. The first chamber 510 is formed between the first mounting plate 114 and the first part 310. The part that is of the flexible thermal sheet 600 and that is located in the first chamber 510 is fastened to the first mounting plate 114. The first mounting plate 114 is thermally connected to the first middle frame 112, so that the first middle frame 112 is thermally connected to the flexible thermal sheet 600.

The second housing 120 may alternatively include a second mounting plate 124 disposed on the side that is of the second middle frame 122 and that faces the second part 320. The second mounting plate 124 is fastened to the second middle frame 122. The second part 320 is mounted on the second mounting plate 124. The second mounting plate 124 is spaced apart from the second part 320. The second chamber 520 is formed between the second mounting plate 124 and the second part 320. A part that is of the flexible thermal sheet 600 and that is located in the second chamber 520 slidably cooperates with the second mounting plate 124. The second mounting plate 124 is thermally connected to the second middle frame 122, so that the second middle frame 122 is thermally connected to the flexible thermal sheet 600.

In this way, the flexible thermal sheet 600 is fastened to the first housing 110, and the flexible thermal sheet 600 is flat after being bonded to the first mounting plate 114. This reduces pulling on the flexible thermal sheet 600. In addition, the flexible thermal sheet 600 slides more smoothly with the second housing 120 through the second mounting plate 124.

It may be understood that the heating unit 400 in the first housing 110 may be disposed in space formed by the first mounting plate 114, the first middle frame 112, and the first rear cover 113, and the heating unit 400 in the first housing 110 may be thermally connected to the flexible thermal sheet 600 through the first middle frame 112 and the first mounting plate 114. The heating unit 400 in the second housing 120 may be disposed in space formed by the second mounting plate 124, the second middle frame 122, and the second rear cover 123, and the heating unit 400 in the second housing 120 may be thermally connected to the flexible thermal sheet 600 through the second middle frame 122 and the second mounting plate 124.

It should be noted that the first middle frame 112 and the first mounting plate 114 may be of an integrated structure, and the second middle frame 122 and the second mounting part 124 may be of an integrated structure.

In some embodiments, when the heating unit 400 is disposed in the first housing 110, the projection of the heating unit 400 in the first housing 110 along the thickness direction of the first housing 110 falls within a range of a projection of the part that is of the flexible thermal sheet 600 and that is located in the first chamber 510 along the thickness direction of the first housing 110.

In this way, heat conduction efficiency of the heating unit 400 in the first housing 110 and the flexible thermal sheet 600 is high, and the heat generated by the heating unit 400 in the first housing 110 may be efficiently transferred to the flexible thermal sheet 600, to transfer the heat to the second housing 120 through the flexible thermal sheet 600.

As shown in FIG. 5 to FIG. 8, the rotating shaft mechanism 200 may include a primary shaft component 210, a first folding component 220, and a second folding component 230. The first folding component 220 and the second folding component 230 are respectively mounted on two opposite sides of the primary shaft component 210. The first folding component 220 and the second folding component 230 may be separately rotatably connected to the primary shaft component 210. The first housing 110 may be fastened to or slidably connected to the first folding component 220. The second housing 120 may be fastened to or slidably connected to the second folding component 230. The first housing 110 may be rotatably connected to the primary shaft component 210 through the first folding component 220. The second housing 120 may be rotatably connected to the primary shaft component 210 through the second folding component 230. The third part 330 is opposite to the first folding component 220, the primary shaft component 210, and the second folding component 230. The first folding component 220, the primary shaft component 210, and the second folding component 230 may respectively support corresponding positions on the third part 330. There is the third chamber 530 between the first folding component 220, the primary shaft component 210, and the second folding component 230 and the third part 330. The flexible thermal sheet 600 slidably cooperates with the first folding component 220, the primary shaft component 210, and the second folding component 230.

In embodiments of the present disclosure, the heating unit 400 is disposed in the first housing 110. When the heating unit 400 is also disposed in the second housing 120, heat generated when the heating unit 400 in the first housing 110 runs is greater than heat generated when the heating unit 400 in the second housing 120 runs.

In this way, a thermally conductive connection between the flexible thermal sheet 600 and the first housing 110 is stable. This helps quickly and effectively conduct heat generated by the heating unit 400 that generates a larger amount of heat in the first housing 110 to the flexible thermal sheet 600, heat may be conducted to the second housing through the flexible thermal sheet 600 and evenly distributed to each part of the first housing 110.

As shown in FIG. 6 to FIG. 8, at least the part that is of the flexible thermal sheet 600 and that is located in the first chamber 510 may be bonded and fastened to the first housing 110 through a second bonding layer 511.

In this way, the flexible thermal sheet 600 and the first housing 110 are easily fastened, and are stable after being bonded and fastened. Relative motion is not likely to occur between the flexible thermal sheet 600 and the first housing 110.

It may be understood that the second bonding layer 511 may be formed by a heat conducting adhesive.

In some examples, the second bonding layer 511 is disposed between the flexible thermal sheet 600 and the first housing 110, and the flexible thermal sheet 600 is bonded and fastened to the first housing 110 through the second bonding layer 511.

In this way, a fastening connection between the flexible thermal sheet 600 and the first housing 110 is stable, the flexible thermal sheet 600 and the first housing 110 are not easily shifted, and the thermally conductive connection between the flexible thermal sheet 600 and the first housing 110 is stable. In this case, the flexible thermal sheet 600 may be in contact with the heating unit 400 in the first housing 110, or the flexible thermal sheet 600 is close to the heating unit 400 in the first housing 110, so that the heat generated by the heating unit 400 in the first housing 110 can be transferred to the flexible thermal sheet 600. Alternatively, the heating unit 400 in the first housing 110 may be in contact with the first housing 110 or close to the first housing 110, and the heat generated by the heating unit 400 in the first housing 110 is transferred to the flexible thermal sheet 600 through the first housing 110.

In an example in which the first housing includes the first middle frame 112 and the first mounting plate 114, the second bonding layer 511 may be disposed between the flexible thermal sheet 600 and the first mounting plate 114, and the flexible thermal sheet 600 is bonded and fastened to the first mounting plate 114 through the second bonding layer 511.

In some examples, the second bonding layer 511 may also be disposed between the flexible thermal sheet 600 and the heating unit 400 in the first housing 110, and the flexible thermal sheet 600 is bonded and fastened to the heating unit 400 in the first housing 110 through the second bonding layer 511, so that the flexible thermal sheet 600 is fastened to the first housing 110 through the second bonding layer 511 and the heating unit 400 in the first housing 110.

In this way, a relative position between the flexible thermal sheet 600 and the heating unit 400 in the first housing 110 is stable. This is conducive facilitating continuous and stable transfer of the heat generated by the heating unit 400 in the first housing 110 to the flexible thermal sheet 600. In this case, the flexible thermal sheet 600 may be in contact with the first housing 110, or the flexible thermal sheet 600 is close to the first housing 110, so that heat on the flexible thermal sheet 600 can be transferred to the first housing 110. The heating unit 400 in the first housing 110 may be in contact with the first housing 110 or close to the first housing 110, so that the heating unit 400 in the first housing 110 is thermally connected to the first housing. The heating unit 400 in the first housing 110 may alternatively be thermally connected to the first housing 110 through the flexible thermal sheet 600.

In some examples, second bonding layers 511 are disposed between the flexible thermal sheet 600 and the first housing 110 and between the flexible thermal sheet 600 and the heating unit 400 in the first housing 110, and the flexible thermal sheet 600 is separately bonded and fastened to the first housing 110 and the heating unit 400 in the first housing 110 through the second bonding layers 511.

It may be understood that, the flexible thermal sheet 600 is close to the first housing 110 and the heating unit 400 in the first housing 110, the flexible thermal sheet 600 may perform heat exchange with the first housing 110 and the heating unit 400 in the first housing 110. When the second bonding layer 511 is formed with a thermally conductive adhesive, the flexible thermal sheet 600 may also perform heat exchange with the first housing 110 and the heating unit 400 through the second bonding layer 511.

In this way, a fastening connection between the flexible thermal sheet 600 and the first housing 110 is stable, the flexible thermal sheet 600 and the first housing 110 are not easy to shift, and a relative position between the flexible thermal sheet 600 and the heating unit 400 is stable. This is conducive to continuous and stable transfer of the heat generated by the heating unit 400 in the first housing 110 to the flexible thermal sheet 600, and is also conducive to continuous and stable transfer of heat on the flexible thermal sheet 600 to the first housing 110.

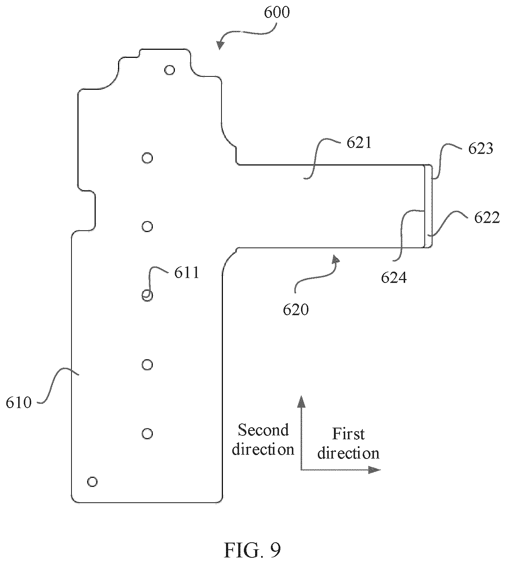

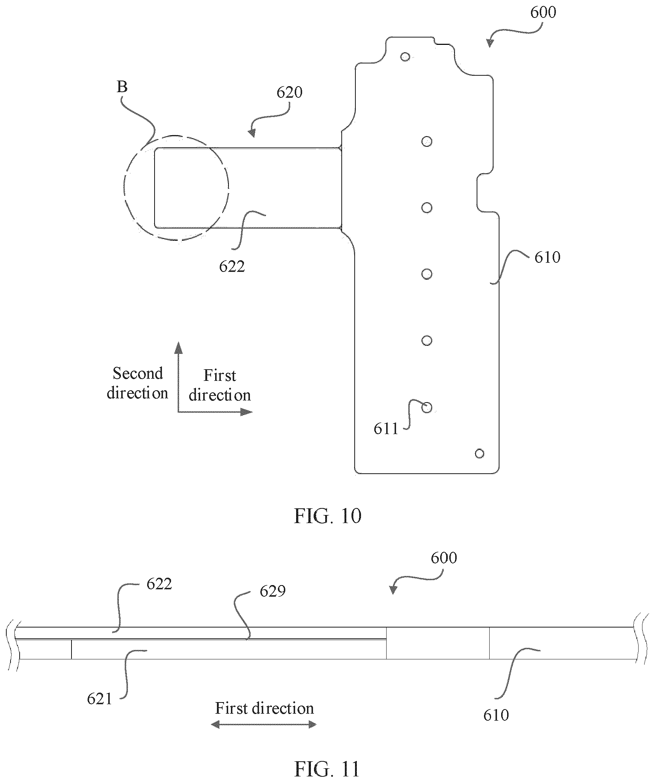

FIG. 9 is another diagram of a side of a flexible thermal sheet of the foldable device in a thickness direction of the flexible thermal sheet according to an embodiment of the present disclosure. FIG. 10 is another diagram of another side of the flexible thermal sheet of the foldable device in the thickness direction of the flexible thermal sheet according to an embodiment of the present disclosure. FIG. 11 is another diagram of a side, in a second direction, of a joint between a graphite sheet part and a laminated part of the flexible thermal sheet of the foldable device according to an embodiment of the present disclosure. A first direction is a direction in which the first housing 110 faces the second housing 120 when the foldable device is in the unfolded state, and the second direction is a length extension direction of the rotating shaft mechanism 200.

Refer to FIG. 5 to FIG. 8. As shown in FIG. 9 to FIG. 11, in embodiments of the present disclosure, the flexible thermal sheet 600 includes a graphite sheet part 610 and a laminated part 620 that are distributed in the first direction. The graphite sheet part 610 is located in the first chamber 510, and is fastened to the first housing 110. The laminated part 620 passes through the third chamber 530 along the third part 330 and extends to the second chamber 520. The laminated part 620 slidably cooperates with the third part 330 and the rotating shaft mechanism 200 and with the second part 320 and the second housing 120. The laminated part 620 includes a graphite sheet layer 621 and an elastic support layer 622 that are stacked, and the elastic support layer 622 is fastened to the graphite sheet layer 621.

It may be understood that the graphite sheet part 610 and the graphite sheet layer 621 may be of an integrated structure.

In this way, good thermal conductivity of graphite can be fully utilized, and heat conduction efficiency of the flexible thermal sheet 600 is high. This helps improve heat dissipation performance of the foldable device, so that the flexible thermal sheet 600 may be light and thin. The laminated part 620 includes the graphite sheet layer 621 and the elastic support layer 622. The elastic support layer 622 may support the graphite sheet layer 621 to flatten the graphite sheet layer 621, and may drive the graphite sheet layer 621 to slide. In this way, a risk that the graphite sheet layer 621 is wrinkled in a sliding process can be further reduced, and the flexible thermal sheet 600 is not easily clamped into the rotating shaft mechanism 200 and gaps between the rotating shaft mechanism 200 and the first housing 110 and the second housing 120. This can reduce an impact of the flexible thermal sheet 600 on unfolding and folding of the foldable device. In addition, the flexible thermal sheet 600 is smooth when the foldable device is in each state. This can reduce an impact on display of the flexible display 300.

It may be understood that the elastic support layer 622 may be bent along with the third part 330 when the foldable device switches from the unfolded state to the folded state, and may be restored to flat along with the third part 330 when the foldable device switches from the folded state to the unfolded state. The elastic support layer 622 may include elastic plastic, elastic metal, or the like.

In this embodiment of the present disclosure, one end that is of the laminated part 620 and that is connected to the graphite sheet part 610 is located in the first chamber 510, and at least the part that is of the laminated part 620 and that is located in the first chamber 510 is fastened to the first housing 110. In this way, a risk that the graphite sheet part 610 is damaged or the laminated part 620 is delaminated due to mutual force generated between the end that is of the laminated part 620 and that is connected to the graphite sheet part 610 and the graphite sheet part 610 may be reduced.

In some embodiments, the part that is of the laminated part 620 and that is located in the first chamber 510 is fastened to the first middle frame 112 or the first mounting plate 114, and when the foldable device moves between the unfolded state and the folded state, the part that is of the laminated part 620 and that is fastened to the first middle frame 112 or the first mounting plate 114 may not be bent. This helps improve reliability of the part that is of the laminated part 620 and that is fastened to the first middle frame 112 or the first mounting plate 114.

In this embodiment of the present disclosure, the elastic support layer 622 includes metal, and rigidity of the metal is greater than rigidity of the graphite sheet layer.

In this way, the elastic support layer 622 may also conduct heat to some extent. This is conducive to improving thermal conductivity of the flexible thermal sheet 600. In addition, it is easy to manufacture a surface of the elastic support layer 622 into a smooth surface. This facilitates sliding of the laminated part 620. In addition, the elastic support layer 622 has stable performance and high strength, and is not easily damaged in a reciprocating sliding process.

It may be understood that the metal may be a copper sheet, an aluminum sheet, a steel sheet, or the like.

As shown in FIG. 9 and FIG. 10, in embodiments of the present disclosure, the part that is of the flexible thermal sheet 600 and that is located in the first chamber 510 is provided with positioning holes 611, and the first housing 110 is provided with positioning protrusions (not shown) corresponding to the positioning holes 611, and the positioning protrusions extend into the corresponding positioning holes 611.

It may be understood that the positioning protrusions may be provided in the first chamber 510, the positioning protrusions are fastened to the first housing 110, and after the positioning protrusions extend into the corresponding positioning holes 611, the flexible thermal sheet 600 may be positioned with the first housing 110.

In this way, the flexible thermal sheet 600 can be accurately mounted at a preset position of the first housing 110 during assembly, and after the flexible thermal sheet 600 is assembled to the first housing 110, the flexible thermal sheet 600 is stable and is not easy to shift.

It may be understood that, in an example in which the flexible thermal sheet 600 may include the graphite sheet part 610 and the laminated part 620, the positioning holes 611 may be provided on the graphite sheet part 610. The part that is of the laminated part 620 and that is located in the first chamber 510 may alternatively be provided with positioning holes 611.

A plurality of positioning holes 611 may be provided on the flexible thermal sheet 600, and the positioning holes 611 may be through holes.

In an example in which the first housing 110 includes a first mounting plate, positioning protrusions may be provided on the first mounting plate.

As shown in FIG. 9 to FIG. 11, in embodiments of the present disclosure, the graphite sheet part 610 and the graphite sheet layer 621 are of an integrated structure, and a thickness of the graphite sheet part 610 may be greater than a thickness of the graphite sheet layer 621.

This is conducive to disposing the elastic support layer 622, is conducive to reducing a thickness of the laminated part 620, and is conducive to sliding assembly of the laminated part 620 in the second chamber 520 and the third chamber 530. Limitation on internal space of the second chamber 520 and the third chamber 530 may be reduced.

It may be understood that, one side of an entire graphite sheet may be cut, to form a graphite sheet layer 621 at a cut and thinned position, and form the graphite sheet part 610 at an uncut position.

As shown in FIG. 11, in this embodiment of the present disclosure, a thickness of the elastic support layer 622 is less than the thickness of the graphite sheet layer 621.

In this way, heat conduction efficiency of the laminated part 620 is high. This helps improve heat dissipation performance of the foldable device.

In this embodiment of the present disclosure, a first bonding layer 629 is disposed between the graphite sheet layer 621 and the elastic support layer 622, and the graphite sheet layer 621 and the elastic support layer 622 are bonded and fastened through the first bonding layer 629.

In this way, the graphite sheet layer 621 and the elastic support layer 622 are easily fastened, and are stable and difficult to shift after being bonded and fastened. This is conducive to support of the elastic support layer 622 for the graphite sheet layer 621, and the graphite sheet layer 621 is not prone to wrinkles.

It may be understood that the graphite sheet layer 621 and the elastic support layer 622 are both provided with the first bonding layer 629 at an overlapping position, and are bonded and fastened through the first bonding layers 629. The first bonding layer 629 may be formed with a thermally conductive adhesive.

In some examples, the thickness of the graphite sheet part 610 is equal to the thickness of the laminated part 620.

In this way, the flexible thermal sheet 600 is flat, and a risk that the flexible thermal sheet 600 affects display of the flexible display 300 can be reduced.

For example, the thickness of the graphite sheet part 610 may be 0.1 mm, so that the thickness of the graphite sheet layer 621 is 0.07 mm, a thickness of the first bonding layer 629 is 0.01 mm, and a thickness of the elastic support layer 622 is 0.02 mm.

For example, the thickness of the graphite sheet part 610 may be 0.12 mm, so that the thickness of the graphite sheet layer 621 is 0.08 mm, the thickness of the first bonding layer 629 is 0.01 mm, and a thickness of the elastic support layer 622 is 0.03 mm.

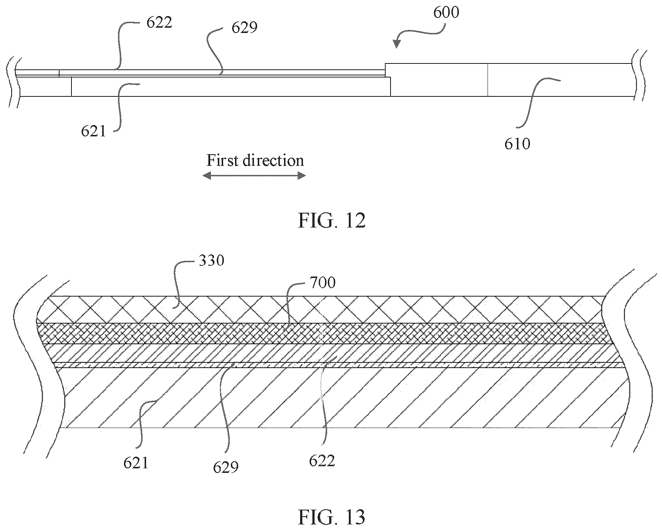

FIG. 12 is another diagram of a side, in the second direction, of a joint between the graphite sheet part and the laminated part of the flexible thermal sheet of the foldable device according to an embodiment of the present disclosure.

As shown in FIG. 12, in some examples, the thickness of the graphite sheet part 610 is greater than the thickness of the laminated part 620.

This can reduce limitations on internal space of the second chamber 520 and the third chamber 530, and is conducive to sliding cooperation between the flexible thermal sheet 600 and the second part 320, the third part 330, the second housing 120, and the rotating shaft mechanism 200.

For example, the thickness of the graphite sheet part 610 may be 0.1 mm, so that the thickness of the graphite sheet layer 621 is 0.06 mm, the thickness of the first bonding layer 629 is 0.01 mm, and a thickness of the elastic support layer 622 is 0.02 mm.

For example, the thickness of the graphite sheet part 610 may be 0.12 mm, so that the thickness of the graphite sheet layer 621 is 0.08 mm, the thickness of the first bonding layer 629 is 0.01 mm, and a thickness of the elastic support layer 622 is 0.02 mm.

It may be understood that a thickness of the graphite sheet part 610 may be determined based on a height of the first chamber 510 in the thickness direction of the foldable device, a thickness of the laminated part 620 may be determined based on heights of the second chamber 520 and the third chamber 530 in the thickness direction of the foldable device, and thicknesses of the graphite sheet layer 621 and the elastic support layer 622 may be determined based on the thickness of the laminated part 620 and required thermal conductivity and bending performance of the laminated part 620.

In some examples, a first sinking platform is provided on a side that is of the first housing 110 and that faces the first part 310. A second sinking platform is provided on a side that is of the second housing 120 and that faces the second part 320. A third sinking platform is provided on a side that is of the rotating shaft mechanism 200 and that faces the third part 330. The first chamber 510 is formed between the first sinking platform and the first part 310. The second chamber 520 is formed between the second sinking platform and the second part 320. The third chamber 530 is formed between the third sinking platform and the third part 330. At least a part of the flexible thermal sheet 600 is disposed on the first sinking platform, the second sinking platform, and the third sinking platform. In some embodiments, at least a part of the laminated part 620 is located on the second sinking platform and/or the third sinking platform. In a process in which the foldable device moves between the unfolded state and the folded state, the laminated part 620 slides relative to the second housing and/or the rotating shaft mechanism. A sinking platform is disposed to limit sliding of the laminated part. This is conducive to improving structural reliability of the laminated part. This can further reduce a risk that the flexible thermal sheet 600 affects display of the flexible display 300.

FIG. 13 is another diagram of a cross section perpendicular to the second direction at the third part and the laminated part of the foldable device according to an embodiment of the present disclosure.

Refer to FIG. 6 to FIG. 8. As shown in FIG. 13, in this embodiment of the present disclosure, the elastic support layer 622 is fastened to a side surface that is of the graphite sheet layer 621 and that is close to the flexible display 300.

In this way, the graphite sheet layer 621 is close to the second housing 120. This is conducive to improving heat conduction efficiency of the flexible thermal sheet 600 and the second housing 120.

As shown in FIG. 13, in this embodiment of the present disclosure, a lubricating medium 700 configured to reduce friction between the flexible thermal sheet 600 and the third part 330 and/or the rotating shaft mechanism 200 is disposed in the third chamber 530. This facilitates sliding of the flexible thermal sheet 600.

It may be understood that the lubricating medium 700 may be lubricating grease, a lubricating film, or the like.

In some examples, the lubricating medium 700 is disposed between the rotating shaft mechanism 200 and the flexible thermal sheet 600.

In this way, a risk of jamming caused by the rotating shaft mechanism 200 to sliding of the flexible thermal sheet 600 can be reduced.

In some examples, the lubricating medium 700 is disposed between the third part 330 and the flexible thermal sheet 600.

In this way, an impact caused by the flexible thermal sheet 600 on the flexible display 300 in a sliding process can be reduced.

In some examples, the lubricating medium 700 is disposed between the rotating shaft mechanism 200 and the flexible thermal sheet 600 and between the third part 330 and the flexible thermal sheet 600.

In this way, friction between the flexible thermal sheet 600, the third part 330, and the rotating shaft mechanism 200 is small. This is conducive to sliding of the flexible thermal sheet 600, and has a low risk of affecting display of the flexible display 300.

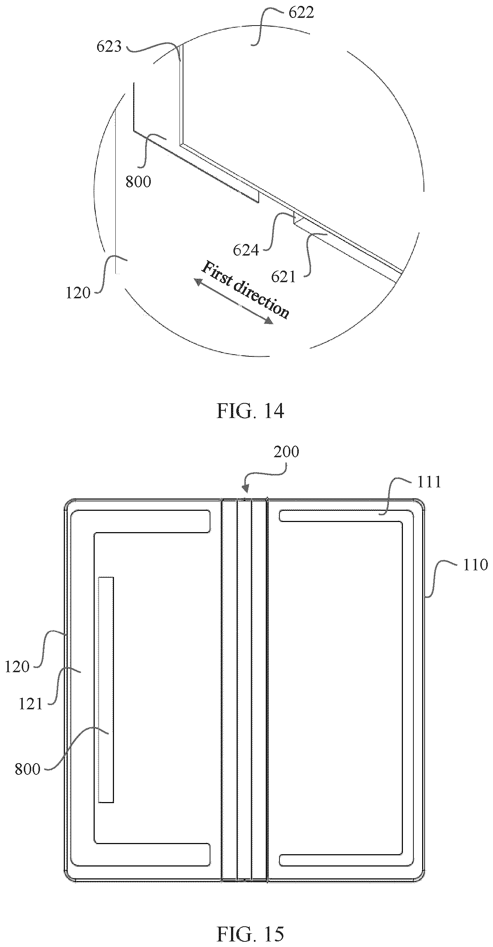

FIG. 14 is an enlarged view of a part A in FIG. 5.

Refer to FIG. 9. As shown in FIG. 14, in this embodiment of the present disclosure, the elastic support layer 622 includes a first end 623 away from the graphite sheet part 610 in the first direction, the graphite sheet layer 621 includes a second end 624 away from the graphite sheet part 610 in the first direction, and the first end 623 protrudes from the second end 624.

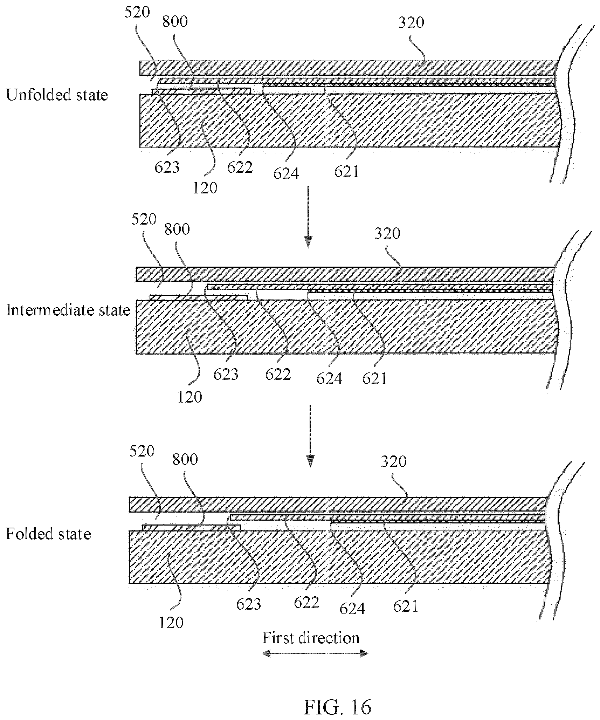

FIG. 15 is another diagram in which the flexible display and the flexible thermal sheet on the side that is of the foldable device in the unfolded state and on which the flexible display is disposed are hidden according to an embodiment of the present disclosure. FIG. 16 is another diagram of cooperation between the laminated part and Mylar in a process in which the foldable device switches from the unfolded state to the folded state according to an embodiment of the present disclosure.

Refer to FIG. 14. As shown in FIG. 15 and FIG. 16, the second housing 120 is fastened to Mylar 800, Mylar 800 is located in the second chamber 520, Mylar 800 is spaced apart from the second end 624 in the first direction, at least a part of Mylar 800 and a part that is of the elastic support layer 622 and that protrudes from the second end 624 overlap in a thickness direction of the second housing 120, and the first end 623 slidably cooperates with Mylar 800.

It may be understood that, when the foldable device is in the folded state, the unfolded state, or the intermediate state in a process of switching between the folded state and the unfolded state, Mylar 800 is spaced apart from the second end 624 in the first direction, at least the part of Mylar 800 and the part that is of the elastic support layer 622 and that protrudes from the second end 624 overlap in the thickness direction of the second housing 120.

Mylar 800 may be disposed at an end that is away from the rotating shaft mechanism 200 and that is of the second housing 120 in the first direction.

In this way, in a process in which the flexible thermal sheet 600 slides relative to the second housing 120, the first end 623 touches Mylar 800, and does not touch the second housing 120. This can reduce a risk that the first end 623 touches the second housing 120 and causes an abnormal sound.

It should be noted that a thickness of Mylar 600 may be less than the thickness of the graphite sheet layer 621.

In this embodiment of the present disclosure, Mylar 800 may be Teflon Mylar. In this way, Teflon Mylar has self-lubricating performance, and can reduce friction between the elastic support layer 622 and Mylar 800, and is conducive to sliding of the flexible thermal sheet 600.

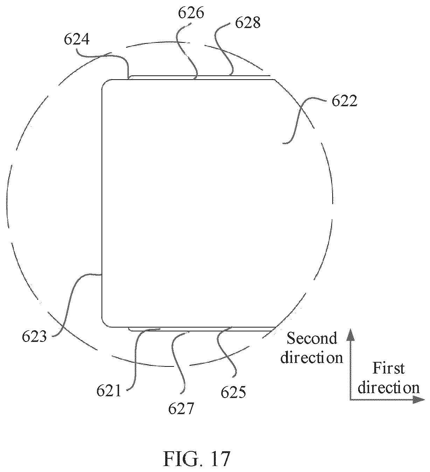

FIG. 17 is an enlarged view of a part B in FIG. 10.

As shown in FIG. 17, in this embodiment of the present disclosure, the elastic support layer 622 includes a first side 625 and a second side 626 that are opposite to each other in the second direction. The graphite sheet layer 621 includes a third side 627 and a fourth side 628 that are opposite to each other in the second direction. The first side 625 is adjacent to the third side 627. The second side 626 is adjacent to the fourth side 628. The third side 627 protrudes from the first side 625. The fourth side 628 protrudes from the second side 626. A width, in the second direction, of a part that is of the graphite sheet layer 621 and that protrudes from the first side 625 is less than a height of the second chamber 520 in a thickness direction of the foldable device and is less than a height of a third chamber 530 in the thickness direction of the foldable device. A width, in the second direction, of a part that is of the graphite sheet layer 621 and that protrudes from the second side 626 is less than the height of the second chamber 520 in the thickness direction of the foldable device and is less than the height of the third chamber 530 in the thickness direction of the foldable device.

In this way, the part that protrudes from the first side 625 and the part that protrudes from the second side 626 that are of the graphite sheet layer 621 may prevent the elastic support layer 622 from touching the second housing 120 and/or the rotating shaft mechanism 200 on two sides in the second direction. This can reduce a risk that the elastic support layer 622 touches the second housing 120 and/or the rotating shaft mechanism 200 on two sides in the second direction and causes an abnormal sound.

It may be understood that the part that protrudes from the first side 625 and the part that protrudes from the second side 626 that are of the graphite sheet layer 621 are fastened to the elastic support layer 622 through overlapping parts between the graphite sheet layer 621 and the elastic support layer 622. Widths of the part that protrudes from the first side 625 and the part that protrudes from the second side 626 that are of the graphite sheet layer 621 are narrow in the second direction. In a sliding process of the elastic support layer 622, the part that protrudes from the first side 625 and the part that protrudes from the second side 626 that are of the graphite sheet layer 621 move together under driving of the elastic support layer 622. In addition, even if the part that protrudes from the first side 625 and the part that protrudes from the second side 626 that are of the graphite sheet layer 621 generate wrinkles, a flexible display 300 is not easily squeezed, and a risk of affecting display of the flexible display 300 is low.

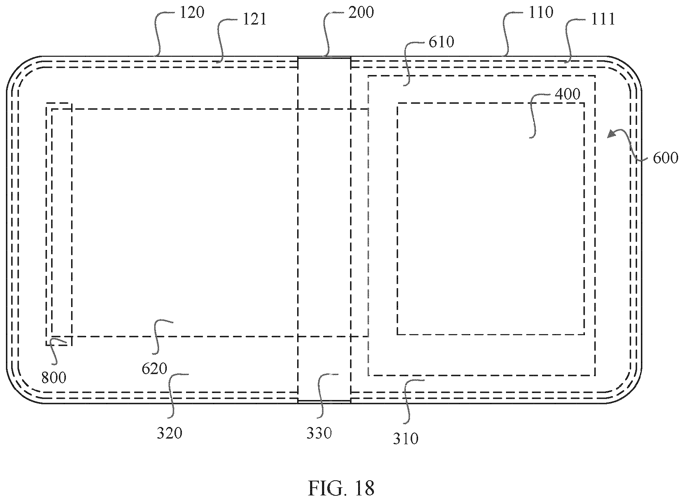

FIG. 18 is another diagram of the side that is of the foldable device in the unfolded state and on which the flexible display is disposed according to an embodiment of the present disclosure.

Refer to FIG. 5. As shown in FIG. 18, in this embodiment of the present disclosure, the first part 310 is bonded and fastened to the first housing 110 through a first bonding strip 111, and a second part 320 is bonded and fastened to a second housing 120 through a second bonding strip 121. A first chamber 510 is provided between the first part 310, the first bonding strip 111, and the first housing 110, and a second chamber 520 is provided between the second part 320, the second bonding strip 121, and the second housing 120.

In this way, the first bonding strip 111 may bond and fasten the first part 310 to the first housing 110, and the first bonding strip 111 may separate the first part 310 from the first housing 110, to form the first chamber 510 for accommodating a flexible display 300. The second bonding strip 121 may bond and fasten the second part 320 to the second housing 120, and the second bonding strip 121 may separate the second part 320 from the second housing 120, to form the second chamber 520 for the flexible display 300 to slide. There is no need to separately dispose a structure like a sinking platform that is spaced apart from the flexible display 300 to form the first chamber 510 and the second chamber 520 for mounting a flexible thermal sheet 600 with the flexible display 300, so that a structure of the foldable device can be simple, and the foldable device can also be thin.

It may be understood that a thickness of the first bonding strip 111 may be greater than a thickness of a part that is of the flexible thermal sheet 600 and that is located in the first chamber 510. For example, the first bonding strip 111 may be 0.2 mm thicker than the part that is of the flexible thermal sheet 600 and that is located in the first chamber 510. For example, the thickness of the part that is of the flexible thermal sheet 600 and that is located in the first chamber 510 may be 0.1 mm, and the thickness of the first bonding strip 111 may be 0.3 mm.

A thickness of the second bonding strip 121 may be greater than a thickness of a part that is of the flexible thermal sheet 600 and that is located in the second chamber 520. For example, the second bonding strip 121 may be 0.2 mm thicker than the part that is of the flexible thermal sheet 600 and that is located in the second chamber 520. For example, the thickness of the part that is of the flexible thermal sheet 600 and that is located in the second chamber 520 may be 0.1 mm, and the thickness of the second bonding strip 121 may be 0.3 mm.

In an example in which the first housing 110 includes a first mounting plate 114, the first part 310 may be bonded and fastened to the first mounting plate 114 through the first bonding strip 111, and the first chamber 510 may be formed between the first mounting plate 114, the first bonding strip 111, and the first part 310. In an example in which the second housing 120 includes a second mounting plate 124, the second part 320 may be bonded and fastened to the second mounting plate 124 through the second bonding strip 121, and the second chamber 520 may be formed between the second mounting plate 124, the second bonding strip 121, and the second part 320.

In this embodiment of the present disclosure, the first bonding strip 111 is disposed at an edge of the first part 310, and the second bonding strip 121 is disposed at an edge of the second part 320.

In this way, sizes of the first chamber 510 and the second chamber 520 are large. This is conducive to increasing sizes of a sliding part in the second chamber 520 and a part fastened to the first chamber 510 that are of the flexible display 300, and is conducive to heat dissipation efficiency of the foldable device.

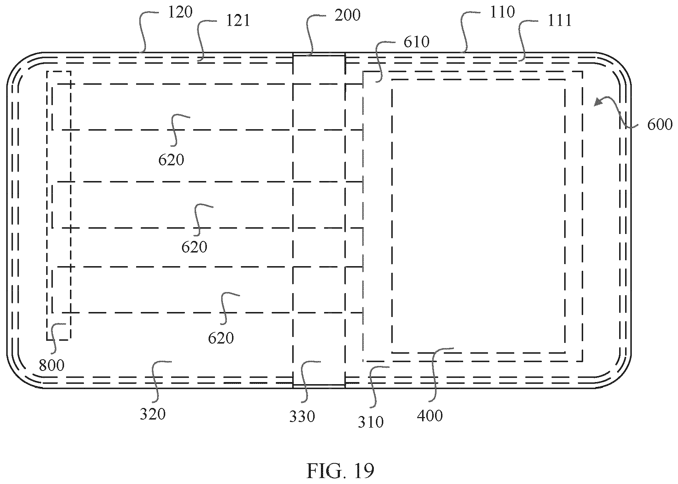

FIG. 19 is another diagram of the side that is of the foldable device in the unfolded state and on which the flexible display is disposed according to an embodiment of the present disclosure.

As shown in FIG. 19, in some examples, parts of the flexible thermal sheet 600 that are located in the second chamber 520 and the third chamber 530 may include a plurality of segments that are spaced along an axial direction of the rotating shaft mechanism 200 and that are parallel to each other.

In an example in which the flexible thermal sheet 600 includes the graphite sheet part 610 and the laminated part 620, the flexible thermal sheet 600 may include a plurality of laminated parts 620 that are distributed at intervals along the axial direction of the rotating shaft mechanism 200 and that are parallel to each other, and one end of each laminated part 620 is connected to the graphite sheet part 610.

In this way, space of the second chamber 520 and the third chamber 530 may be fully used to arrange the flexible thermal sheet 600. This is conducive to improving thermal conductivity of the flexible thermal sheet 600 and the second housing 120. In addition, a quantity of disposed flexible thermal sheets 600 is small, and reliability is high.

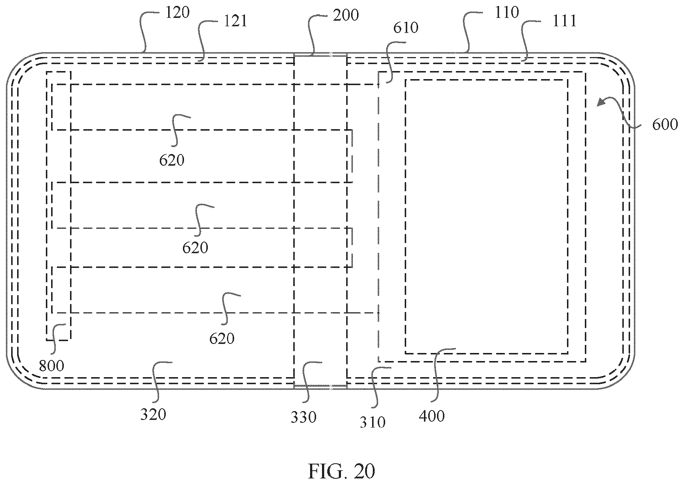

FIG. 20 is another diagram of the side that is of the foldable device in the unfolded state and on which the flexible display is disposed according to an embodiment of the present disclosure.

As shown in FIG. 20, in some examples in which the flexible thermal sheet 600 includes the plurality of laminated parts 620, one end that is of each laminated part 620 of the flexible thermal sheet 600 and that is connected to the graphite sheet part 610 is located in the first chamber 510, at least a part that is of each laminated part 620 and that is located in the first chamber 510 is fastened to the first housing 110, and parts that are of all laminated parts 620 and that are fastened to the first housing 110 may be integrally connected. In this way, a risk that the graphite sheet part 610 is easily damaged due to uneven stress generated by the plurality of laminated parts 620 connected to the graphite sheet part 610 on the graphite sheet part 610 can be reduced.

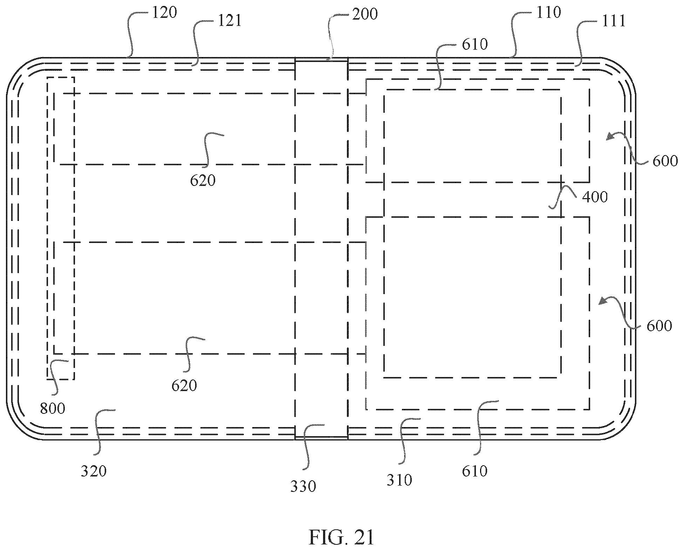

FIG. 21 is another diagram of the side that is of the foldable device in the unfolded state and on which the flexible display is disposed according to an embodiment of the present disclosure.

As shown in FIG. 21, in some examples, the foldable device may include a plurality of flexible thermal sheets 600 distributed along the axial direction of the rotating shaft mechanism 200. In this way, limitation on space of the first chamber 510 can be reduced, the space of the first chamber 510 can be fully utilized to arrange the flexible thermal sheets 600, and thermal conductivity of the flexible thermal sheets 600 and the first housing 110 can be improved.

In the descriptions of embodiments of the present disclosure, it should be noted that, unless otherwise explicitly stipulated and restricted, terms "mounting", "link", and "connection" should be understood broadly, which, for example, may be a fixed connection, or may be an indirect connection by using a medium, or may be an internal communication between two components, or may be an interactive relationship between two components. A person of ordinary skill in the art may understand specific meanings of the terms in embodiments of the present disclosure based on a specific case.

In the specification, claims, and accompanying drawings of embodiments of the present disclosure, the terms "first", "second", "third", "fourth", and so on (if existent) are intended to distinguish between similar objects but do not necessarily indicate a specific order or sequence.

Finally, it should be noted that the foregoing embodiments are merely intended to describe the technical solutions of embodiments of the present disclosure, and are not intended to limit embodiments of the present disclosure. Although embodiments of the present disclosure are described in detail with reference to the foregoing embodiments, a person of ordinary skill in the art should understand that they may still make modifications to the technical solutions described in the foregoing embodiments or make equivalent replacements to some or all technical features thereof, without departing from the scope of the technical solutions of embodiments of the present disclosure.

## Claims

1. A foldable device, comprising a first housing (110), a second housing (120), a heating unit (400), a rotating shaft mechanism (200), a flexible display (300), and a flexible thermal sheet (600), wherein the first housing (110) and the second housing (120) are rotatably connected through the rotating shaft mechanism (200), and the heating unit (400) is disposed in at least one of the first housing (110) and the second housing (120);
the flexible display (300) comprises a first part (310), a second part (320), and a third part (330), wherein the first part (310) is mounted on the first housing (110), and a first chamber (510) is provided between the first part (310) and the first housing (110); the second part (320) is mounted on the second housing (120), and a second chamber (520) is provided between the second part (320) and the second housing (120); and the third part (330) is opposite to the rotating shaft mechanism (200), a third chamber (530) is provided between the third part (330) and the rotating shaft mechanism (200), and two ends of the third chamber (530) respectively communicate with the first chamber (510) and the second chamber (520);
the flexible thermal sheet (600) is disposed in space formed by the first chamber (510), the second chamber (520), and the third chamber (530), at least a part that is of the flexible thermal sheet (600) and that is located in the first chamber (510) is fastened to the first housing (110), the flexible thermal sheet (600) passes through the third chamber (530) along the third part (330) and extends to the second chamber (520), and the flexible thermal sheet (600) slidably cooperates with the third part (330) and the rotating shaft mechanism (200) and with the second part (320) and the second housing (120); and
the flexible thermal sheet (600) is thermally connected to the heating unit (400), the first housing (110), and the second housing (120);
wherein the flexible thermal sheet (600) comprises a graphite sheet part (610) and a laminated part (620), the graphite sheet part (610) is located in the first chamber (510) and is fastened to the first housing (110), the laminated part (620) passes through the third chamber (530) along the third part (330) and extends to the second chamber (520), and the laminated part (620) slidably cooperates with the third part (330) and the rotating shaft mechanism (200) and with the second part (320) and the second housing (120); and
the laminated part (620) comprises a graphite sheet layer (621) and an elastic support layer (622) that are stacked, and the elastic support layer (622) is fastened to the graphite sheet layer (621).

2. The foldable device according to claim 1, wherein one end that is of the laminated part (620) and that is connected to the graphite sheet part (610) is located in the first chamber (510), and at least a part that is of the laminated part (620) and that is located in the first chamber (510) is fastened to the first housing (110).

3. The foldable device according to claim 1 or 2, wherein the elastic support layer (622) comprises metal, and rigidity of the metal is greater than rigidity of the graphite sheet layer (621).

4. The foldable device according to any one of claims 1 to 3, wherein the elastic support layer (622) is fastened to a side surface that is of the graphite sheet layer (621) and that is close to the flexible display (300).

5. The foldable device according to claim 4, wherein the elastic support layer (622) comprises a first end (623) away from the graphite sheet part (610) in a first direction, the graphite sheet layer (621) comprises a second end (624) away from the graphite sheet part (610) in the first direction, and the first end (623) protrudes from the second end (624); and
the second housing (120) is fastened to Mylar (800), Mylar (800) is located in the second chamber (520), Mylar (800) is spaced apart from the second end (624) in the first direction, at least a part of Mylar (800) and a part that is of the elastic support layer (622) and that protrudes from the second end (624) overlap in a thickness direction of the second housing (120), and the first end (623) slidably cooperates with Mylar (800), wherein
the first direction is a direction in which the first housing (110) faces the second housing (120) when the foldable device is in an unfolded state.

6. The foldable device according to claim 5, wherein Mylar (800) is Teflon Mylar.

7. The foldable device according to any one of claims 1 to 6, wherein the elastic support layer (622) comprises a first side (625) and a second side (626) opposite to each other in a second direction, the graphite sheet layer (621) comprises a third side (627) and a fourth side (628) opposite to each other in the second direction, the first side (625) is adjacent to the third side (627), the second side (626) is adjacent to the fourth side (628), the third side (627) protrudes from the first side (625), and the fourth side (628) protrudes from the second side (626);
a width, in the second direction, of a part that is of the graphite sheet layer (621) and that protrudes from the first side (625) is less than a height of the second chamber (520) in a thickness direction of the foldable device and is less than a height of the third chamber (530) in the thickness direction of the foldable device; and
a width, in the second direction, of a part that is of the graphite sheet layer (621) and that protrudes from the second side (626) is less than the height of the second chamber (520) in the thickness direction of the foldable device and is less than the height of the third chamber (530) in the thickness direction of the foldable device, wherein
the second direction is a length extension direction of the rotating shaft mechanism (200).

8. The foldable device according to any one of claims 1 to 7, wherein the graphite sheet part (610) and the graphite sheet layer (621) are of an integrated structure, and a thickness of the graphite sheet part (610) is greater than a thickness of the graphite sheet layer (621).

9. The foldable device according to any one of claims 1 to 8, wherein a thickness of the elastic support layer (622) is less than the thickness of the graphite sheet layer (621).

10. The foldable device according to any one of claims 1 to 9, wherein a first bonding layer (629) is disposed between the graphite sheet layer (621) and the elastic support layer (622), and the graphite sheet layer (621) and the elastic support layer (622) are bonded and fastened through the first bonding layer (629).

11. The foldable device according to any one of claims 1 to 10, wherein when the heating unit (400) is disposed in the first housing (110), a projection of the heating unit (400) in the first housing (110) along a thickness direction of the first housing (110) falls within a range of a projection of the part that is of the flexible thermal sheet (600) and that is located in the first chamber (510) along the thickness direction of the first housing (110).

12. The foldable device according to any one of claims 1 to 11, wherein the heating unit (400) is disposed in the first housing (110); and
when the heating unit (400) is also disposed in the second housing (120), heat generated when the heating unit (400) in the first housing (110) runs is greater than heat generated when the heating unit (400) in the second housing (120) runs.

13. The foldable device according to any one of claims 1 to 12, wherein a lubricating medium (700) is disposed between the rotating shaft mechanism (200) and the flexible thermal sheet (600);
a lubricating medium (700) is disposed between the third part (330) and the flexible thermal sheet (600); or
a lubricating medium (700) is disposed between the rotating shaft mechanism (200) and the flexible thermal sheet (600) and between the third part (330) and the flexible thermal sheet (600).

14. The foldable device according to any one of claims 1 to 13, wherein at least the part that is of the flexible thermal sheet (600) and that is located in the first chamber (510) is bonded and fastened to the first housing (110) through a second bonding layer (511).

## Patentansprüche

1. Zusammenklappbare Vorrichtung, umfassend ein erstes Gehäuse (110), ein zweites Gehäuse (120), eine Heizeinheit (400), einen Drehwellenmechanismus (200), eine flexible Anzeige (300) und eine flexible Wärmefolie (600), wobei das erste Gehäuse (110) und das zweite Gehäuse (120) durch den Drehwellenmechanismus (200) drehbar verbunden sind und die Heizeinheit (400) in mindestens einem des ersten Gehäuses (110) und des zweiten Gehäuses (120) angeordnet ist;
wobei die flexible Anzeige (300) einen ersten Teil (310), einen zweiten Teil (320) und einen dritten Teil (330) umfasst, wobei der erste Teil (310) auf dem ersten Gehäuse (110) montiert ist und eine erste Kammer (510) zwischen dem ersten Teil (310) und dem ersten Gehäuse (110) bereitgestellt ist; der zweite Teil (320) auf dem zweiten Gehäuse (120) montiert ist und eine zweite Kammer (520) zwischen dem zweiten Teil (320) und dem zweiten Gehäuse (120) bereitgestellt ist; und der dritte Teil (330) dem Drehwellenmechanismus (200) gegenüberliegt, eine dritte Kammer (530) zwischen dem dritten Teil (330) und dem Drehwellenmechanismus (200) bereitgestellt ist und zwei Enden der dritten Kammer (530) mit der ersten Kammer (510) beziehungsweise der zweiten Kammer (520) kommunizieren;
wobei die flexible Wärmefolie (600) in einem Raum angeordnet ist, der durch die erste Kammer (510), die zweite Kammer (520) und die dritte Kammer (530) gebildet ist, mindestens ein Teil, welcher der flexiblen Wärmefolie (600) angehört und der sich in der ersten Kammer (510) befindet, an dem ersten Gehäuse (110) befestigt ist, die flexible Wärmefolie (600) entlang des dritten Teiles (330) durch die dritte Kammer (530) verläuft und sich zu der zweiten Kammer (520) erstreckt und die flexible Wärmefolie (600) gleitbar mit dem dritten Teil (330) und dem Drehwellenmechanismus (200) und mit dem zweiten Teil (320) und dem zweiten Gehäuse (120) zusammenwirkt; und
die flexible Wärmefolie (600) thermisch mit der Heizeinheit (400), dem ersten Gehäuse (110) und dem zweiten Gehäuse (120) verbunden ist;
wobei die flexible Wärmefolie (600) einen Graphitfolienteil (610) und einen laminierten Teil (620) umfasst, sich der Graphitfolienteil (610) in der ersten Kammer (510) befindet und an dem ersten Gehäuse (110) befestigt ist, der laminierte Teil (620) entlang des dritten Teiles (330) durch die dritte Kammer (530) verläuft und sich zu der zweiten Kammer (520) erstreckt und der laminierte Teil (620) gleitbar mit dem dritten Teil (330) und dem Drehwellenmechanismus (200) und mit dem zweiten Teil (320) und dem zweiten Gehäuse (120) zusammenwirkt; und
der laminierte Teil (620) eine Graphitfolienschicht (621) und eine elastischen Stützschicht (622) umfasst, die gestapelt sind, und die elastische Stützschicht (622) an der Graphitfolienschicht (621) befestigt ist.

2. Zusammenklappbare Vorrichtung nach Anspruch 1, wobei sich ein Ende, das dem laminierten Teil (620) angehört und das mit dem Graphitfolienteil (610) verbunden ist, in der ersten Kammer (510) befindet und mindestens ein Teil, der dem laminierten Teil (620) angehört und der sich in der ersten Kammer (510) befindet, an dem ersten Gehäuse (110) befestigt ist.

3. Zusammenklappbare Vorrichtung nach Anspruch 1 oder 2, wobei die elastische Stützschicht (622) Metall umfasst und eine Steifigkeit des Metalls größer als eine Steifigkeit der Graphitfolienschicht (621) ist.

4. Zusammenklappbare Vorrichtung nach einem der Ansprüche 1 bis 3, wobei die elastische Stützschicht (622) an einer Seitenfläche befestigt ist, die der Graphitfolienschicht (621) angehört und die nahe der flexiblen Anzeige (300) ist.

5. Zusammenklappbare Vorrichtung nach Anspruch 4, wobei die elastische Stützschicht (622) ein erstes Ende (623) umfasst, das in einer ersten Richtung von dem Graphitfolienteil (610) abgewandt ist, die Graphitfolienschicht (621) ein zweites Ende (624) umfasst, das in der ersten Richtung von dem Graphitfolienteil (610) abgewandt ist, und das erste Ende (623) aus dem zweiten Ende (624) vorspringt; und
das zweite Gehäuse (120) an Mylar (800) befestigt ist, sich Mylar (800) in der zweiten Kammer (520) befindet, Mylar (800) in der ersten Richtung von dem zweiten Ende (624) beabstandet ist, sich mindestens ein Teil von Mylar (800) und ein Teil, welcher der elastischen Stützschicht (622) angehört und der aus dem zweiten Ende (624) vorspringt, in einer Dickenrichtung des zweiten Gehäuses (120) überlappen und das erste Ende (623) gleitbar mit Mylar (800) zusammenwirkt, wobei
die erste Richtung eine Richtung ist, in der das erste Gehäuse (110) dem zweiten Gehäuse (120) zugewandt ist, wenn sich die zusammenklappbare Vorrichtung in einem ausgeklappten Zustand befindet.

6. Zusammenklappbare Vorrichtung nach Anspruch 5, wobei Mylar (800) Teflon-Mylar ist.

7. Zusammenklappbare Vorrichtung nach einem der Ansprüche 1 bis 6, wobei die elastische Stützschicht (622) eine erste Seite (625) und eine zweite Seite (626) umfasst, die sich in einer zweiten Richtung gegenüberliegen, die Graphitfolienschicht (621) eine dritte Seite (627) und eine vierte Seite (628) umfasst, die sich in der zweiten Richtung gegenüberliegen, die erste Seite (625) zu der dritten Seite (627) benachbart ist, die zweite Seite (626) zu der vierten Seite (628) benachbart ist, die dritte Seite (627) aus der ersten Seite (625) vorspringt und die vierte Seite (628) aus der zweiten Seite (626) vorspringt;
eine Breite, in der zweiten Richtung, eines Teiles, welcher der Graphitfolienschicht (621) angehört und der aus der ersten Seite (625) vorspringt, kleiner als eine Höhe der zweiten Kammer (520) in einer Dickenrichtung der zusammenklappbaren Vorrichtung ist und kleiner als eine Höhe der dritten Kammer (530) in der Dickenrichtung der zusammenklappbaren Vorrichtung ist; und
eine Breite, in der zweiten Richtung, eines Teiles, welcher der Graphitfolienschicht (621) angehört und der aus der zweiten Seite (626) vorspringt, kleiner als die Höhe der zweiten Kammer (520) in der Dickenrichtung der zusammenklappbaren Vorrichtung ist und kleiner als die Höhe der dritten Kammer (530) in der Dickenrichtung der zusammenklappbaren Vorrichtung ist, wobei
die zweite Richtung eine Längenerstreckungsrichtung des Drehwellenmechanismus (200) ist.

8. Zusammenklappbare Vorrichtung nach einem der Ansprüche 1 bis 7, wobei der Graphitfolienteil (610) und die Graphitfolienschicht (621) eine integrierte Struktur sind und eine Dicke des Graphitfolienteils (610) größer als eine Dicke der Graphitfolienschicht (621) ist.

9. Zusammenklappbare Vorrichtung nach einem der Ansprüche 1 bis 8, wobei eine Dicke der elastischen Stützschicht (622) kleiner als die Dicke der Graphitfolienschicht (621) ist.

10. Zusammenklappbare Vorrichtung nach einem der Ansprüche 1 bis 9, wobei eine erste Bindeschicht (629) zwischen der Graphitfolienschicht (621) und der elastischen Stützschicht (622) angeordnet ist und die Graphitfolienschicht (621) und die elastische Stützschicht (622) über die erste Bindeschicht (629) gebunden und befestigt sind.

11. Zusammenklappbare Vorrichtung nach einem der Ansprüche 1 bis 10, wobei, wenn die Heizeinheit (400) in dem ersten Gehäuse (110) angeordnet ist, ein Vorstand der Heizeinheit (400) in dem ersten Gehäuse (110) entlang einer Dickenrichtung des ersten Gehäuses (110) in einen Bereich eines Vorstands des Teiles, welcher der flexiblen Wärmefolie (600) angehört und der sich in der ersten Kammer (510) befindet, entlang der Dickenrichtung des ersten Gehäuses (110) fällt.

12. Zusammenklappbare Vorrichtung nach einem der Ansprüche 1 bis 11, wobei die Heizeinheit (400) in dem ersten Gehäuse (110) angeordnet ist; und
wenn die Heizeinheit (400) ebenfalls in dem zweiten Gehäuse (120) angeordnet ist, die Wärme, die erzeugt wird, wenn die Heizeinheit (400) in dem ersten Gehäuse (110) läuft, größer als die Wärme ist, die erzeugt wird, wenn die Heizeinheit (400) in dem zweiten Gehäuse (120) läuft.

13. Zusammenklappbare Vorrichtung nach einem der Ansprüche 1 bis 12, wobei ein Schmiermedium (700) zwischen dem Drehwellenmechanismus (200) und der flexiblen Wärmefolie (600) angeordnet ist;
ein Schmiermedium (700) zwischen dem dritten Teil (330) und der flexiblen Wärmefolie (600) angeordnet ist; oder
ein Schmiermittel (700) zwischen dem Drehwellenmechanismus (200) und der flexiblen Wärmefolie (600) und zwischen dem dritten Teil (330) und der flexiblen Wärmefolie (600) angeordnet ist.

14. Zusammenklappbare Vorrichtung nach einem der Ansprüche 1 bis 13, wobei mindestens der Teil, welcher der flexiblen Wärmefolie (600) angehört und der sich in der ersten Kammer (510) befindet, über eine zweite Bindeschicht (511) mit dem ersten Gehäuse (110) gebunden und daran befestigt ist.

## Revendications

1. Dispositif pliable, comprenant un premier boîtier (110), un second boîtier (120), une unité de chauffage (400), un mécanisme d'arbre rotatif (200), un dispositif d'affichage flexible (300) et une feuille thermique flexible (600), dans lequel le premier boîtier (110) et le second boîtier (120) sont reliés de manière rotative par l'intermédiaire du mécanisme d'arbre rotatif (200), et l'unité de chauffage (400) est disposée dans au moins l'un du premier boîtier (110) et du second boîtier (120) ;
le dispositif d'affichage flexible (300) comprend une première partie (310), une deuxième partie (320) et une troisième partie (330), dans lequel la première partie (310) est montée sur le premier boîtier (110), et une première chambre (510) est prévue entre la première partie (310) et le premier boîtier (110) ; la deuxième partie (320) est montée sur le second boîtier (120), et une deuxième chambre (520) est prévue entre la deuxième partie (320) et le second boîtier (120) ; et la troisième partie (330) est opposée au mécanisme d'arbre rotatif (200), une troisième chambre (530) est prévue entre la troisième partie (330) et le mécanisme d'arbre rotatif (200), et deux extrémités de la troisième chambre (530) communiquent respectivement avec la première chambre (510) et la deuxième chambre (520) ;
la feuille thermique flexible (600) est disposée dans un espace formé par la première chambre (510), la deuxième chambre (520) et la troisième chambre (530), au moins une partie de la feuille thermique flexible (600) qui est située dans la première chambre (510) est fixée au premier boîtier (110), la feuille thermique flexible (600) traverse la troisième chambre (530) le long de la troisième partie (330) et s'étend jusqu'à la deuxième chambre (520), et la feuille thermique flexible (600) coopère de manière coulissante avec la troisième partie (330) et le mécanisme d'arbre rotatif (200), ainsi qu'avec la deuxième partie (320) et le second boîtier (120) ; et
la feuille thermique flexible (600) est thermiquement reliée à l'unité de chauffage (400), au premier boîtier (110) et au second boîtier (120) ;
dans lequel la feuille thermique flexible (600) comprend une partie en feuille de graphite (610) et une partie laminée (620), la partie en feuille de graphite (610) est située dans la première chambre (510) et fixée au premier boîtier (110), la partie laminée (620) traverse la troisième chambre (530) le long de la troisième partie (330) et s'étend jusqu'à la deuxième chambre (520), et la partie laminée (620) coopère de manière coulissante avec la troisième partie (330) et le mécanisme d'arbre rotatif (200), ainsi qu'avec la deuxième partie (320) et le second boîtier (120) ; et
la partie laminée (620) comprend une couche en feuille de graphite (621) et une couche de support élastique (622) qui sont empilées, et la couche de support élastique (622) est fixée à la couche en feuille de graphite (621).

2. Dispositif pliable selon la revendication 1, dans lequel une extrémité de la partie laminée (620) qui est reliée à la partie en feuille de graphite (610) est située dans la première chambre (510), et au moins une partie de la partie laminée (620) qui est située dans la première chambre (510) est fixée au premier boîtier (110).

3. Dispositif pliable selon la revendication 1 ou 2, dans lequel la couche de support élastique (622) comprend du métal, et la rigidité du métal est supérieure à la rigidité de la couche en feuille de graphite (621).

4. Dispositif pliable selon l'une quelconque des revendications 1 à 3, dans lequel la couche de support élastique (622) est fixée à une surface latérale de la couche en feuille de graphite (621) qui est proche du dispositif d'affichage flexible (300).

5. Dispositif pliable selon la revendication 4, dans lequel la couche de support élastique (622) comprend une première extrémité (623) éloignée de la partie en feuille de graphite (610) dans une première direction, la couche en feuille de graphite (621) comprend une seconde extrémité (624) éloignée de la partie en feuille de graphite (610) dans la première direction, et la première extrémité (623) fait saillie de la seconde extrémité (624) ; et
le second boîtier (120) est fixé à un Mylar (800), le Mylar (800) est situé dans la deuxième chambre (520), le Mylar (800) est espacé de la seconde extrémité (624) dans la première direction, au moins une partie du Mylar (800) et une partie de la couche de support élastique (622) qui fait saillie de la seconde extrémité (624) se chevauchent dans une direction d'épaisseur du second boîtier (120) et la première extrémité (623) coopère de manière coulissante avec le Mylar (800), dans lequel
la première direction est une direction dans laquelle le premier boîtier (110) fait face au second boîtier (120) lorsque le dispositif pliable se trouve dans un état déplié.

6. Dispositif pliable selon la revendication 5, dans lequel le Mylar (800) est un Mylar enduit de Téflon.

7. Dispositif pliable selon l'une quelconque des revendications 1 à 6, dans lequel la couche de support élastique (622) comprend un premier côté (625) et un deuxième côté (626) opposés l'un à l'autre dans une seconde direction, la couche en feuille de graphite (621) comprend un troisième côté (627) et un quatrième côté (628) opposés l'un à l'autre dans la seconde direction, le premier côté (625) est adjacent au troisième côté (627), le deuxième côté (626) est adjacent au quatrième côté (628), le troisième côté (627) fait saillie du premier côté (625) et le quatrième côté (628) fait saillie du deuxième côté (626) ;
une largeur, dans la seconde direction, d'une partie de la couche en feuille de graphite (621) qui fait saillie du premier côté (625) est inférieure à une hauteur de la deuxième chambre (520) dans une direction d'épaisseur du dispositif pliable et est inférieure à une hauteur de la troisième chambre (530) dans la direction d'épaisseur du dispositif pliable ; et
une largeur, dans la seconde direction, d'une partie de la couche en feuille de graphite (621) qui fait saillie du deuxième côté (626) est inférieure à la hauteur de la deuxième chambre (520) dans la direction d'épaisseur du dispositif pliable et est inférieure à la hauteur de la troisième chambre (530) dans la direction d'épaisseur du dispositif pliable, dans lequel
la seconde direction est une direction d'extension de longueur du mécanisme d'arbre rotatif (200).

8. Dispositif pliable selon l'une quelconque des revendications 1 à 7, dans lequel la partie en feuille de graphite (610) et la couche en feuille de graphite (621) forment une structure intégrée, et une épaisseur de la partie en feuille de graphite (610) est supérieure à une épaisseur de la couche en feuille de graphite (621).

9. Dispositif pliable selon l'une quelconque des revendications 1 à 8, dans lequel une épaisseur de la couche de support élastique (622) est inférieure à l'épaisseur de la couche en feuille de graphite (621).

10. Dispositif pliable selon l'une quelconque des revendications 1 à 9, dans lequel une première couche de liaison (629) est disposée entre la couche en feuille de graphite (621) et la couche de support élastique (622), et la couche en feuille de graphite (621) et la couche de support élastique (622) sont liées et fixées par l'intermédiaire de la première couche de liaison (629).

11. Dispositif pliable selon l'une quelconque des revendications 1 à 10, dans lequel lorsque l'unité de chauffage (400) est disposée dans le premier boîtier (110), une projection de l'unité de chauffage (400) dans le premier boîtier (110) le long d'une direction d'épaisseur du premier boîtier (110) tombe dans une plage d'une projection de la partie de la feuille thermique flexible (600) qui est située dans la première chambre (510) le long de la direction d'épaisseur du premier boîtier (110).

12. Dispositif pliable selon l'une quelconque des revendications 1 à 11, dans lequel l'unité de chauffage (400) est disposée dans le premier boîtier (110) ; et
lorsque l'unité de chauffage (400) est également disposée dans le second boîtier (120), la chaleur générée lorsque l'unité de chauffage (400) dans le premier boîtier (110) fonctionne est supérieure à la chaleur générée lorsque l'unité de chauffage (400) dans le second boîtier (120) fonctionne.

13. Dispositif pliable selon l'une quelconque des revendications 1 à 12, dans lequel un milieu lubrifiant (700) est disposé entre le mécanisme d'arbre rotatif (200) et la feuille thermique flexible (600) ;
un milieu lubrifiant (700) est disposé entre la troisième partie (330) et la feuille thermique flexible (600) ; ou
un milieu lubrifiant (700) est disposé entre le mécanisme d'arbre rotatif (200) et la feuille thermique flexible (600) et entre la troisième partie (330) et la feuille thermique flexible (600).

14. Dispositif pliable selon l'une quelconque des revendications 1 à 13, dans lequel au moins la partie de la feuille thermique flexible (600) qui est située dans la première chambre (510) est liée et fixée au premier boîtier (110) par l'intermédiaire d'une seconde couche de liaison (511).
